# EUROPEAN PATENT SPECIFICATION

(11) **EP 1 256 032 B1**
(45) Date of publication and mention of the grant of the patent: **21.04.2010**
(21) Application number: 01902387.8
(22) Date of filing: 02.02.2001
(51) Int. Cl.: G03F 7/027, G03C 9/08

(54) **LIQUID, RADIATION-CURABLE COMPOSITION, ESPECIALLY FOR STEREOLITHOGRAPHY**
FLÜSSIGE, STRAHLENHÄRTBARE ZUSAMMENSETZUNG INSBESONDERE FÜR STEREOLITHOGRAPHIE
COMPOSITION LIQUIDE DURCISSABLE PAR RAYONNEMENT, DESTINEE NOTAMMENT A LA STEREOLITHOGRAPHIE

(30) Priority: 08.02.2000 US 181052 P
(43) Date of publication of application: 13.11.2002
(73) Proprietor: Huntsman Advanced Materials (Switzerland) GmbH, 4057 Basel (CH)
(72) Inventor: JOHNSON, David, L., Saugus, CA 91350 (US); LEYDEN, Richard, Noel, Topanga Cannon, CA 90290 (US); PATEL, Ranjana, C., Bishop's Stortford, Herts CM22 7PP (GB)
(74) Representative: Hoffmann, Daniele
(86) International application number: PCT/EP2001/001115
(87) International publication number: WO 2001/059524

(56) References cited:
- WO-A-98/36323
- WO-A-99/50711
- US-A- 5 476 748
- US-A- 5 605 941
- US-A- 5 972 563

## Description

The present invention relates to a liquid, radiation-curable composition which is particularly suitable for the production of three-dimensional shaped articles by means of stereolithography, to a process for the production of a cured product and, in particular, for the stereolithographic production of a three-dimensional shaped article from this composition.

The production of three-dimensional articles of complex shape by means of stereolithography has been known for a relatively long time. In this technique the desired shaped article is built up from a liquid, radiation-curable composition with the aid of a recurring, alternating sequence of two steps (a) and (b); in step (a), a layer of the liquid, radiation-curable composition, one boundary of which is the surface of the composition, is cured with the aid of appropriate radiation, generally radiation produced by a preferably computer-controlled laser source, within a surface region which corresponds to the desired cross-sectional area of the shaped article to be formed, at the height of this layer, and in step (b) the cured layer is covered with a new layer of the liquid, radiation-curable composition, and the sequence of steps (a) and (b) is repeated until a so-called green model of the desired shape is finished. This green model is, in general, not yet fully cured and must therefore, normally, be subjected to post-curing.

The mechanical strength of the green model (modulus of elasticity, fracture strength), also referred to as green strength, constitutes an important property of the green model and is determined essentially by the nature of the stereolithographic-resin composition employed. Other important properties of a stereolithographic-resin composition include a high sensitivity for the radiation employed in the course of curing and a minimum curl factor, permitting high shape definition of the green model. In addition, for example, the precured material layers should be readily wettable by the liquid stereolithographic-resin composition, and of course not only the green model but also the ultimately cured shaped article should have optimum mechanical properties.

Liquid, radiation-curable compositions for stereolithography which meet the above mentioned requirements are described, for example, in U.S. Pat. No. 5,476,748. These compositions are so-called hybrid systems, comprising free-radically and cationically photopolymerizable components. Such hybrid systems have been shown through considerable effort to provide the required balance of accuracy, speed and final properties. In addition to the liquid, free-radically polymerizable component, these hybrid compositions typically comprise at least:
(A) from 40 to 80 percent by weight of a liquid difunctional or more highly functional epoxy resin or of a liquid mixture consisting of difunctional or more highly functional epoxy resins;
(B) from 0.1 to 10 percent by weight of a cationic photoinitiator or of a mixture of cationic photoinitiators; and
(C) from 0.1 to 10 percent by weight of a free-radical photoinitiator or of a mixture of free-radical photoinitiators; and
(D) from 5 to 40 percent by weight of a certain hydroxy compound.
   This hydroxy component (D) is selected from the group consisting of OH-terminated polyethers, polyesters and polyurethanes and is present in the compositions in a quantity of at least 5 percent by weight; the free-radically polymerizable component of said compositions additionally comprises the following constituents:
(E) from 0 to 15 percent by weight of at least one liquid poly(meth)acrylate having a (meth)acrylate functionality of more than 2, and
(F) from 5 to 40 percent by weight of at least one liquid cycloaliphatic or aromatic diacrylate, the content of component (E) being not more than 50 percent by weight of the entire (meth)acrylate content.

U.S. Pat. No. 5,972,563 discloses a liquid, radiation-curable composition comprising in addition to a liquid, free-radically polymerizable component at least the following additional components:
(A) from 40 to 80 percent by weight of a liquid difunctional or more highly functional epoxy resin or of a liquid mixture consisting of difunctional or more highly functional epoxy resins;
(B) from 0.1 to 10 percent by weight of a cationic photoinitiator or of a mixture of cationic photoinitiators; and
(C) from 0.1 to 10 percent by weight of a free-radical photoinitiator or of a mixture of free-radical photoinitiators; and, in addition to the abovementioned components,
(D) up to 40 percent by weight of a hydroxy compound,
   in which composition
   component (D) is selected from the group consisting of:
   (D1) phenolic compounds having at least 2 hydroxyl groups,
   (D2) phenolic compounds having at least 2 hydroxyl groups, which are reacted with ethylene oxide, proplyene oxide or with ethylene oxide and propylene oxide,
   (D3) aliphatic hydroxy compounds having not more than 80 carbon atoms,
   (D4) compounds having at least one hydroxyl group and at least one epoxide group, and
   (D5) a mixture of at least 2 of the compounds mentioned under (D1) to (D4),
   and component (D) is present in the compositions in a quantity of at least 2 percent by weight; the free-radically polymerizable component comprises at least
(E) from 4 to 30 percent by weight of at least one liquid poly(meth)acrylate having a (meth)acrylate functionality of more than 2; and
at least one of components (A) and (D) comprises substances which have aromatic carbon rings in their molecule. As an optional additional component, the novel composition may additionally, in particular, comprise (F) one or more di(meth)acrylates, preferably in a quantity of from 5 to 40 percent by weight.

US-A-5 605 941 also discloses a method of producing three-dimensional objects.

Each of the photopolymerizable compositions discussed above produces cured articles having balanced excellent green strength and ultimate thermal/mechanical properties. Applicants herein have now found surprisingly that selected hybrid compositions are capable of producing cured articles in stereolithography process systems with enhanced properties without the use of a free radical photoinitiator.

The inventive curing systems herein contain a hybrid curing component comprising
(A) 40 to 80 percent by weight of a liquid component consisting of one or more than one polyfunctional compound having at least two groups capable of reacting via or as a result of a ring-opening mechanism to form a polymeric network,
(B) 0.1 to 10 percent by weight of a cationic photoinitiator or a mixture of cationic photoinitiators,
(C) 2 to 30 percent by weight of a compound having at least one unsaturated group and at least one hydroxy group in its molecule,
(D) 0 to 40 percent by weight of a hydroxy compound having no unsaturated groups,
(E) 0 to 30 percent by weight of at least one liquid poly(meth)acrylate having a functionality of more than 2 and having no hydroxy groups,
(F) 0 to 40 percent by weight of at least one liquid cycloaliphatic or aromatic di(meth)acrylate having no hydroxy groups, and
(G) 0 to 10 percent by weight of a reactive diluent,
wherein the sum of components (A), (B), (C), (D), (E), (F) and (G) is 100 percent by weight, and components (C), (D), (E), (F) and (G) are different, and the composition contains no free radical initiator.

Preferably, component (E) is not more than 50 percent by weight of the entire (meth)acrylate content.

Hybrid compositions are commonly understood in the field of stereolithography to mean mixtures of free-radically curable and cationically curable components, most commonly mixtures of at least multifunctional epoxy resins and multifunctional (meth)acrylates. The phrase "hybrid composition" is used herein for a composition containing both cationic activated, ring opening components such as epoxides, and free-radical activated (meth)acrylate components even though the overall composition is free of free radical photoinitiator. The essential characteristic of the hybrid compositions herein is the presence of at least an effective amount of a compound having at least one terminal and/or pendant unsaturated group and at least one hydroxyl group in its molecule along with a conventional cationically curing component. Preferred compounds having at least one terminal and/or pendant unsaturated group and at least one hydroxyl group are hydroxy mono- and poly-acrylates, hydroxy mono- and polymethacrylates and hydroxy mono- and poly-vinylethers.

Examples of conventional cationically curing components are compounds that polymerize via a ring-opening reaction, such as epoxies, oxetanes, and tetrahydropyrans, to name a few.

The liquid component (A) consisting of one or more than one polyfunctional compound having at least two groups capable of reacting via or as a result of a ring-opening mechanism to form a polymeric network, that is used in the novel compositions, are expediently resins which are liquid at room temperature and which on average possess more than one, preferably two or more groups which can be cationically activated. Such activatable groups are for example oxirane- (epoxide), oxetane-, tetrahydropyran- and lactone-rings in the molecule. The resins may have an aliphatic, aromatic, cycloaliphatic, araliphatic or heterocyclic structure; they contain the ring groups as side groups, or the epoxide group can form part of an alicyclic or heterocyclic ring system. Resins of these types are known in general terms and are commercially available. Preferably, component (A) contains oxirane (epoxide) rings in the molecule.

Polyglycidyl esters and poly(β-methylglycidyl) esters are one example of suitable epoxy resins. They are obtainable by reacting a compound having at least two carboxyl groups in the molecule with epichlorohydrin or glycerol dichlorohydrin or β-methylepichlorohydrin. The reaction is expediently carried out in the presence of bases. The compounds having at least two carboxyl groups in the molecule can in this case be, for example, aliphatic polycarboxylic acids, such as glutaric acid, adipic acid, pimelic acid, suberic acid, azelaic acid, sebacic acid or dimerized or trimerized linoleic acid. Likewise, however, it is also possible to employ cycloaliphatic polycarboxylic acids, for example tetrahydrophthalic acid, 4-methyltetrahydrophthalic acid, hexahydrophthalic acid or 4-methylhexahydrophthalic acid. It is also possible to use aromatic polycarboxylic acids such as, for example, phthalic acid, isophthalic acid, trimellitic acid or pyromellitic acid, or else carboxyl-terminated adducts, for example of trimellitic acid and polyols, for example glycerol or 2,2-bis(4-hydroxycyclohexyl)-propane, can be used.

Polyglycidyl ethers or poly(β-methylglycidyl) ethers obtainable by reacting a compound having at least two free alcoholic hydroxyl groups and/or phenolic hydroxyl groups with a suitably substituted epichlorohydrin under alkaline conditions or in the presence of an acidic catalyst followed by alkali treatment can likewise be used. Ethers of this type are derived, for example, from acyclic alcohols, such as ethylene glycol, diethylene glycol and higher poly(oxyethylene) glycols, propane-1,2-diol, or poly(oxypropylene) glycols, propane-1,3-diol, butane-1 ,4-diol, poly(oxytetramethylene) glycols, pentane-1,5-diol, hexane-1,6-diol, hexane-2,4,6-triol, glycerol, 1,1,1-trimethylolpropane, bistrimethylolpropane, pentaerythritol, sorbitol, and from polyepichlorohydrins. Suitable glycidyl ethers can also be obtained, however, from cycloaliphatic alcohols, such as 1,3- or 1,4-dihydroxycyclohexane, bis(4-hydroxycyclohexyl)methane, 2,2-bis(4-hydroxycyclohexyl)propane or 1,1-bis(hydroxymethyl)cyclohex-3-ene, or they possess aromatic rings, such as N,N-bis(2-hydroxyethyl)aniline or p,p'-bis(2-hydroxyethylamino)diphenylmethane.

Particularly important representatives of polyglycidyl ethers or poly(β-methylglycidyl) ethers are based on phenols; either on monocylic phenols, for example on resorcinol or hydroquinone, or on polycyclic phenols, for example on bis(4-hydroxyphenyl)methane (bisphenol F), 2,2-bis(4-hydroxyphenyl)propane (bisphenol A), or on condensation products, obtained under acidic conditions, of phenols or cresols with formaldehyde, such as phenol novolaks and cresol novolaks. These compounds are particularly preferred as epoxy resins for the present invention, especially diglycidyl ethers based on bisphenol A and bisphenol F and mixtures thereof.

Poly(N-glycidyl) compounds are likewise suitable for the purposes of the present invention and are obtainable, for example, by dehydrochlorination of the reaction products of epichlorohydrin with amines containing at least two amine hydrogen atoms. These amines may, for example, be n-butylamine, aniline, toluidine, m-xylylenediamine, bis(4-aminophenyl)methane or bis(4-methylaminophenyl)methane. However, other examples of poly(N-glycidyl) compounds include N,N'-diglycidyl derivatives of cycloalkyleneureas, such as ethyleneurea or 1,3-propyleneurea, and N,N'-diglycidyl derivatives of hydantoins, such as of 5,5-dimethylhydantoin.

Poly(S-glycidyl) compounds are also suitable for component (A) of the novel compositions, examples being di-S-glycidyl derivatives derived from dithiols, for example ethane-1,2-dithiol or bis(4-mercaptomethylphenyl) ether.

Examples of epoxide compounds in which the epoxide groups form part of an alicyclic or heterocyclic ring system include bis(2,3-epoxycyclopentyl) ether, 2,3-epoxycyclopentyl glycidyl ether, 1,2-bis(2,3-epoxycyclopentyloxy)ethane, bis(4-hydroxycyclohexyl)methane diglycidyl ether, 2,2-bis(4-hydroxycyclohexyl)propane diglycidyl ether, 3,4-epoxycyciohexyl-methyl 3,4-epoxycyclohexanecarboxylate, 3,4-epoxy-6-methyl-cyclohexylmethyl 3,4-epoxy-6-methylcyclohexanecarboxylate, di(3,4-epoxycyclohexylmethyl) hexanedioate, di(3,4-epoxy-6-methylcyclohexylmethyl) hexanedioate, ethylenebis(3,4-epoxycyclohexane-carboxylate, ethanediol di(3,4-epoxycyclohexylmethyl) ether, vinylcyclohexene dioxide, dicyclopentadiene diepoxide or 2-(3,4-epoxycyclohexyl-5,5-spiro-3,4-epoxy)cyclohexane-1,3-dioxane.

However, it is also possible to employ epoxy resins in which the 1,2-epoxide groups are attached to different heteroatoms or functional groups. Examples of these compounds include the N,N,O-triglycidyl derivative of 4-aminophenol, the glycidyl ether/glycidyl ester of salicylic acid, N-glycidyl-N'-(2-glycidyloxypropyl)-5,5-dimethylhydantoin or 2-glycidyloxy-1,3-bis(5,5-dimethyl-1-glycidylhydantoin-3-yl)propane.

It is also possible to employ epoxy resins containing at least one epoxycyclohexyl group that is bonded directly or indirectly to a group containing at least one silicon atom. These materials may be linear, branched, or cyclic in structure. Preferred linear epoxy-functional silicone monomers are bis[2(3{7oxabicyclo[4,1,0]heptyl})ethyl]-1,1,3,3-tetramethyldisiloxane, and bis[2(2,3-epoxybicyclo[2,2,1]heptyl)ethyl]-1,1,3,3-tetramethyldisiloxane. Another type of suitable resins of this type are oligomeric polysiloxanes containing pendant epoxycyclohexyl groups, either as homopolymers or copolymers. Still another type of epoxy-functional silicon-containing material which may be used for the fluid medium of this invention are cyclic silicone monomer or oligomers. Particularly preferred examples are exemplified in U.S. Pat. No. 5,639,413, which is incorporated herein by reference.

Also conceivable is the use of liquid prereacted adducts of epoxy resins, such as those mentioned above, with hardeners for epoxy resins.

Examples of compounds, other than epoxides, capable of being activated via a cationic compound include oxetane compounds, such as trimethylene oxide, 3,3-dimethyloxetane and 3,3-dichloromethyloxetane, 3-ethyl-3-phenoxymethyloxetane, and bis(3-ethyl-3-methyloxy)-butane; oxalane compounds, such as tetrahydrofuran and 2,3-dimethyl-tetrahydrafuran; cyclic acetal compounds, such as trioxane, 1,3-dioxalane and 1,3,6-trioxancycloctane; cyclic lactone compounds, such as propiolactone and caprolactone. Particularly preferred oxetane compounds are taught in U.S. Pat. No. 5,463,084, which is incorporated herein by reference. It is of course also possible to use liquid mixtures of the cationically initiated resins described above in the novel compositions.

The preferred hybrid compositions contain at least 40 and up to 85 percent by weight of component (A) based on the overall composition. Preferably (A) is present in an amount of 40 to 80, particularly from 50 to 80, more preferably 60 to 80, most preferably from 65 to 80 percent by weight, based on the overall weight of the composition.

As component (B) of the novel compositions it is possible to employ a host of known and industrially tried and tested cationic photoinitiators for epoxy resins. Examples of these are onium salts with anions of weak nucleophilicity. Examples thereof are halonium salts, iodosyl salts or sulfonium salts, as are described in EP-A-0 153 904, sulfoxonium salts, as described for example in EP-A-0 035 969, EP-A-0 044 274, EP-A-0 054 509 and in EP-A-0 164 314, or diazonium salts, as described for example in US-A-3,708,296. Other cationic photoinitiators are metallocene salts, as described for example in EP-A-0 094 914 and in EP-A-0 094 915.

An overview of further commonplace onium salt initiators and/or metallocene salts is offered by "UV-Curing, Science and Technology", (Editor: S. P. Pappas, Technology Marketing Corp., 642 Westover Road, Stanford, Connecticut, USA) or "Chemistry & Technology of UV & EB Formulations for Coatings, Inks & Paints", Vol. 3 (edited by P. K. T. Oldring).

Preferred compositions are those comprising as component (B) a compound of the formula (B-I) or (B-II) 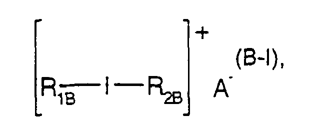 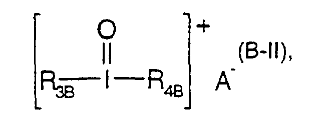 in which R_{1B}, R_{2B}, R_{3B}, and R_{4B}, independently of one another are C₆-C₁₈aryl which is unsubstituted or substituted by appropriate radicals, and
- A⁻: is CF₃SO₃⁻ or an anion of the formula [LQ_{mB}]⁻, where
- L: is boron, phosphorus, arsenic or antimony,
- Q: is a halogen atom, or some of the radicals Q in an anion LQₘ⁻ may also be hydroxyl groups, and
- mB: is an integer corresponding to the valency of L enlarged by 1.

Examples of C₆-C₁₈aryl in this context are phenyl, naphthyl, anthryl and phenanthryl. In these substituents present for appropriate radicals are alkyl, preferably C₁-C₆alkyl, such as methyl, ethyl, n-propyl, isopropyl, n-butyl, sec-butyl, isobutyl, tert-butyl or the various pentyl or hexyl isomers, alkoxy, preferably C₁-C₆alkoxy, such as methoxy, ethoxy, propoxy, butoxy, pentoxy or hexoxy, alkylthio, preferably C₁-C₆alkylthio, such as methylthio, ethylthio, propylthio, butylthio, pentylthio or hexylthio, halogen, such as fluorine, chlorine, bromine or iodine, amino groups, cyano groups, nitro groups or arylthio, such as phenylthio. Examples of preferred halogen atoms Q are chlorine and, in particular, fluorine. Preferred anions LQ_{mB} are BF₄⁻, PF₆⁻, AsF₆⁻, SbF₆⁻ and SbF₅(OH)⁻.

Further preferred compositions are those.comprising as component (B) a compound of the formula (B-III) 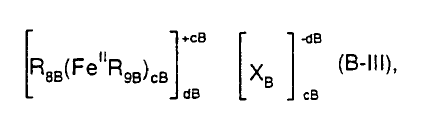 in which
- cB: is 1 or 2,
- dB: is 1, 2, 3, 4 or 5,
- X_{B}: is a non-nucleophilic anion, especially PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ and n-C₈F₁₇SO₃⁻,
- R_{8B}: is a π-arene and
- R_{9B}: is an anion of a π-arene, especially a cyclopentadienyl anion.

Examples of π-arenes as R_{8B} and anions of π-arenes as R_{9B} can be found in EP-A-0 094 915. Examples of preferred π-arenes as R_{8B} are toluene, xylene, ethylbenzene, cumene, methoxybenzene, methylnaphthalene, pyrene, perylene, stilbene, diphenylene oxide and diphenylene sulfide. Cumene, methyl naphthalene or stilbene are particularly preferred. Examples of non-nucleophilic anions X⁻ are FSO₃⁻, anions of organic sulfonic acids, of carboxylic acids or of anions LQ_{mB}⁻. Preferred anions are derived from partially fluoro- or perfluoro-aliphatic or partially fluoro- or perfluoro-aromatic carboxylic acids such as CF₃SO₃⁻, C₂F₅SO₃⁻, n-C₃F₇SO₃⁻, n-C₄F₉SO₃⁻, n-C₆F₁₃SO₃⁻ , n-C₈F₁₇SO₃⁻ , or in particular from partially fluoro- or perfluoro-aliphatic or partially fluoro- or perfluoro-aromatic organic sulfonic acids, for example from C₆F₅SO₃⁻, or preferably are anions LQ_{mB}⁻, such as BF₄⁻, PF₆⁻, AsF₆⁻, SbF₆⁻, and SbF₅(OH)⁻. Preference is given to PF₆⁻, AsF₆⁻, SbF₆⁻, CF₃SO₃⁻, C₂F₅SO₃⁻, n-C₃F₇SO₃⁻, n-C₄F₉SO₃⁻, n-C₆F₁₃SO₃⁻ and n-C₈F₁₇SO₃⁻.

The metallocene salts can also be employed in combination with oxidizing agents. Such combinations are described in U.S. Pat. No. 5,073,476. In order to increase the light yield it is possible, depending on the type of initiator, also to employ sensitizers. Examples of these are polycyclic aromatic hydrocarbons or aromatic keto compounds. Specific examples of preferred sensitizers are mentioned in U.S. Pat. No. 4,624,912.

Photoinitiator (B) is added in effective quantities, i.e. in quantities from 0.1 to 10, particularly from 0.5 to 5 percent by weight, based on the overall quantity of the composition. If the novel compositions are used for stereolithographic processes, in which laser beams are normally employed, it is essential for the absorption capacity of the composition to be matched, by way of the type and concentration of the photoinitiators, in such a way that the depth of curing at normal laser rate is from approximately 0.1 to 2.5 mm. The overall quantity of photoinitiators in the novel compositions is preferably between 0.5 and 6 percent by weight.

The novel mixtures may also contain various photoinitiators of different sensitivity to radiation of emission lines with different wavelengths. What is achieved by this is, for example, a better utilization of a UVNIS light source which emits emission lines of different wavelengths. In this context it is advantageous for the various photoinitiators to be selected such, and employed in a concentration such, that equal optical absorption is produced with the emission lines used.

A further aspect of this invention is the discovery that the cationic initiator must be balanced in order to obtain suitable photospeed and physical properties. More particularly, Dₚ and E_{c} are affected by the level of cationic photoinitiator. An increase in cationic photoinitiator (B) reduces E_{c} and Dₚ. In other words, additional cationic photoinitiator generally reduces E_{c} and Dₚ. The effect on Dₚ is greater than E_{c} and the result is the need for significantly more energy to cure the resin as cationic photoinitiator is increased. The absolute level of energy and cationic photoinitiator (B) is specific to the wavelength of the laser used. Applicants have found that, in hybrid systems without free radical initiator, the optimum level of cationic photoinitiator falls within the range of 2.5 to 7.0, more preferably 2.5 to 5.0 percent by weight, relative to the total weight.

The novel compositions comprise component (C) in an effective amount to support polymerization when exposed to irradiation from a laser even in the absence of a free radical initiator. Examples of suitable lasers for use in stereolithography systems include

| SLA^{®} (3D Systems) | Wavelength (nm) | Type | Maximum power (mw) |
|---|---|---|---|
| 250 | 325 | HeCd | 40 |
| 350 | 354.7 | Solid State frequency tripled Nd:YV04 | 400 |
| 500 | 351 | Argon ion | 800 |
| 7000 | 354.7 | Solid State frequency tripled Nd:YV04 | 1300 |

More particularly, component (C) is present in an amount of at least 2% by weight based on the overall weight of the composition. Component (C) is preferably selected from compounds having terminal and/or pendant unsaturated groups and hydroxyl groups in the molecule. Acrylates, methacrylates and vinyl ether compounds have the required terminal and/or pendant unsaturated group. However, it is essential that the compounds of component (C) include at least one hydroxyl group. Without intending to be bound by theory, Applicants believe that the hydroxyl groups are essential as a means for overcoming the inherent deficiencies of hybrid free radical and cationic systems that are present due to differences of solubility parameters of the two systems. Polar and non-polar groups are prone to repel each other when in solution. These are represented by the epoxy and acrylate compounds, respectively. As each of these groups cure to form polymeric networks they tend to stay independent of each other. The result is two nearly dependent networks which are not prone to reinforce each other. This lack of support leads to reduced green strength, tensile strength, and elongation. In addition, the repulsive nature of the two networks reduces the accuracy of the system. For this reason, those skilled in the art believed that hybrid systems required distinct curing systems for the free radical and cationically curable components.

Applicants succeeded in solving the above challenges by inventing novel stereolithography compositions whose cured objects-models show higher tensile strength, impact resistance and elongation at break. The novel cure mechanism of the mixture takes advantage of the polarity of the hydroxy acrylate to increase miscibility. The bifunctionality of the hydroxy (meth)acrylate also serves to help entangle the two previously dependent polymeric networks. The extent of entangling and miscibility of the two networks is so great that, in some systems, the (meth)acrylate cure can be initiated by the free radicals from the decomposition of the cationic photoinitiator in the absence of free radical photoinitiator. Removal of free radical photoinitiator may increase green strength without hurting photospeed.

Preferred compounds for use as component (C) are represented by
i) hydroxyl-containing (meth)acrylates having aromatic or cyclic groups of the formulae 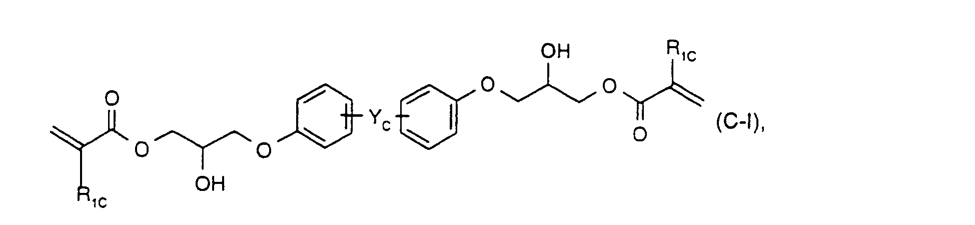 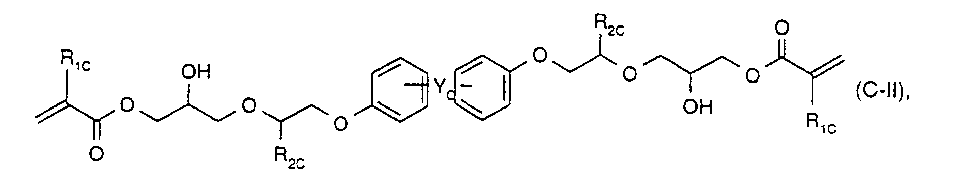 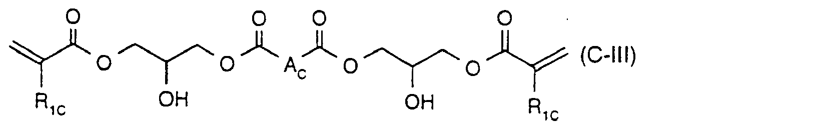 in which
   - R_{1C}: is a hydrogen atom or methyl,
   - Y_{C}: is a direct bond, C₁-C₆alkylene, -S-, -O-, -SO-, -SO₂- or -CO-,
   - R_{2C}: is a C₁-C₈alkyl group, a phenyl group which is unsubstituted or substituted by one or more C₁-C₄alkyl groups, hydroxyl groups or halogen atoms, or is a radical of the formula -CH₂-OR_{3C} in which R_{3C} is a C₁-C₈alkyl group or phenyl group, and
   - A_{C}: is a radical selected from the radicals of the formulae 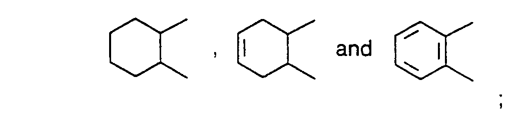 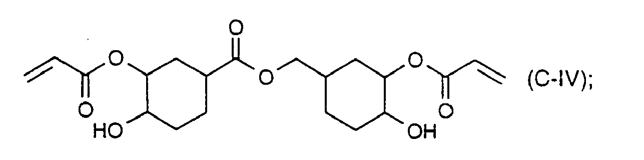 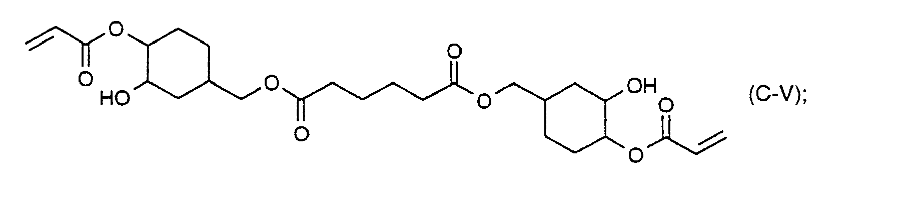
ii) hydroxyl-containing (meth)acrylates according to the formula 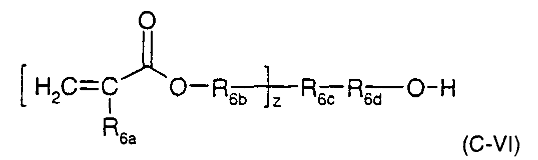
   wherein R₆ₐ is H or C₁-C₄alkyl, R_{6b} and R_{6d} are, independently of one another divalent linear or branched linking groups having 1 to 20 carbon atoms that are optionally substituted one or more times with C₁-C₄alkyl, hydroxyl or interrupted one or more times by a carbonyl group;
   R_{6c} is a multi-valent linear or branched group having 1 to 4 carbon atoms, z is an integer from 1 to 3;
   preferably R₅ₐ is H, R_{6b} and R_{6d} are methylene or ethylene groups and R_{6c} is C and z is 3, or according to the formula 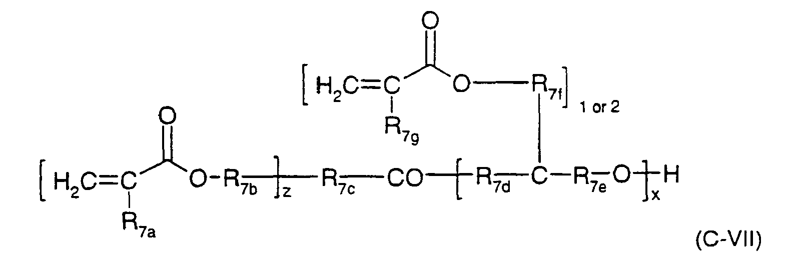
   wherein R₇ₐ and R_{7g} are independently of one another H or C₁-C₄alkyl, R_{7c} is a multi-valent group having 1 to 4 carbon atoms; R_{7b}, R_{7d}, R₇ₑ and R_{7f} are, independently of one another, divalent linear or branched radicals having 1 to 20 carbon atoms that are optionally substituted one or more times with C₁-C₄alkyl, hydroxyl or interrupted one or more times by a carbonyl group; x is an integer from 1 to 4 and z is an integer from 1 to 3;
   preferably R₇ₐ and R_{7g} are H, R_{7b}, R_{7d}, R₇ₑ and R_{7f} are methylene groups, R_{7c} is C, z is 3 and x is 1;
      or according to the formula 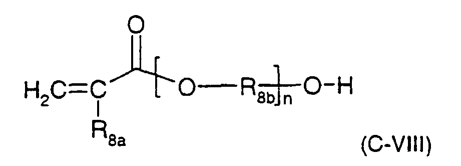
   wherein R₈ₐ is H or C₁-C₄alkyl and R_{8b} is a divalent linear or branched group having 2 to 6 carbon atoms; preferably R₈ₐ is H or methyl and R_{8b} is ethylene;
      or according to the formula 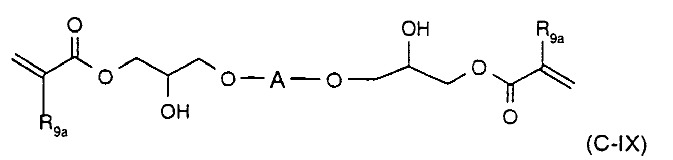
   wherein R₉ₐ is H or C₁-C₄alkyl and A is a divalent linear or branched linking group having 2 to 10 carbon atoms; preferably R₉ₐ is H or methyl and A is a divalent branched group having 3 carbon atoms; A preferably is a divalent linear or branched aliphatic group having 2 to 5 carbon atoms;
iii) hydroxyl-containing vinyl ethers according to the formula 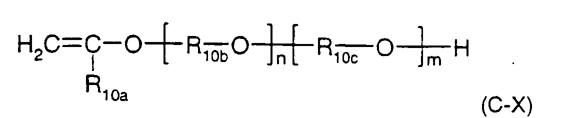 wherein x and y are integers from 0 to 20, R₁₀ₐ is H or C₁-C₄alkyl, R_{10b} is an aliphatic group having 3 to 10 carbon atoms, R_{10c} is a cycloaliphatic, aromatic, aliphatic-aromatic or aliphatic-cycloaliphatic group having 5 to 24 carbon atoms, n is an integer from 0 to 5 and m is an integer from 0 to 5;
iv) hydroxyl-containing poly(meth)acrylates obtained by replacing at least some of the available hydroxyl groups of the compounds of formula (C-I) to (C-IX) with epoxy groups.

These compounds are known and some are commercially available. Their preparation is also described in U.S. Pat. No. 5,605,941 and U.S. Pat. No. 5,880,249.

It is possible to use, for example, pentaerythritol triacrylate, bistrimethylolpropane tetraacrylate, pentaerythritol monohydroxytriacrylate or -methacrylate, or dipentaerythritol monohydroxypentaacrylate or -methacrylate. Further examples of hydroxyl-containing poly(meth)acrylates are reaction products obtained by replacing at least some of the hydroxyl groups with epoxy groups, for example the mono- or di-glycidyl ethers of said triols, with (meth)acrylic acid. Examples of suitable aromatic poly(meth)acrylates include the reaction products obtained by replacing at least some of the hydroxyl groups with epoxy groups, for example polyglycidyl ethers of polyhydric phenols and phenol or cresol novolaks containing hydroxyl groups, with (meth)acrylic acid. Preferably, aromatic (meth)acrylates are used that are obtained as a reaction product of polyglycidyl ethers of trihydric phenols and phenol or cresol novolaks containing three hydroxyl groups, with (meth)acrylic acid.

Suitable partially epoxidized (meth)acrylates can be obtained from cycloaliphatic or aromatic diols, such as 1,4-dihydroxymethylcyclohexane, 2,2-bis(4-hydroxy-cyclohexyl)propane, bis(4-hydroxycyclohexyl)methane, hydroquinone, 4,4'-dihydroxybi-phenyl, bisphenol A, bisphenol F, bisphenol S, ethoxylated or propoxylated bisphenol A, ethoxylated or propoxylated bisphenol F or ethoxylated or propoxylated bisphenol S. (Meth)acrylates of this kind are known and some are commercially available.

Examples of hydroxy-functionalized mono(poly)vinylethers include polyalkyleneglycol monovinylethers, polyalkylene alcohol-terminated polyvinylethers, butanediol monovinylether, cyclohexanediomethanol monovinylether, ethyleneglycol monovinylether, hexanediol monovinylether and ethyleneglycol monovinylether.

Particularly preferred compounds having the requisite terminal and/or pendant unsaturated and hydroxyl group are tetramethylene glycol monovinyl ether, pentaerythritiol triacrylate, dipentaerythrtiol monohydroxypentaacrylate (SR 399), 2-Propenoic acid, 1,6-hexanediylbis[oxy(2-hydroxy-3,1-propanediyl)], Poly(oxy-1,2-ethanediyl), a-(2-methyl-1-oxo-2-propenyl)-w-hydroxy-, 2-Propenoic acid, (1-methyl-1,2-ethanediyl)bis[oxy(2-hydroxy-3,1-propanediyl)] ester, methacrylic acid, 4-benzoyl-3-hydroxyphenyl ester, 2,2-dimethyl-1,3-propanediol monoacrylate, 4-hydroxyphenyl methacrylate, 2-(2-hydroxy-3-tert-butyl-5-methylbenzyl)-4-methyl-6-tert-butylphenyl methacrylate, (1-methylethylidene) bis[4,1phenyleneoxy(2-hydroxy-3,1-propanediyl)] diacrylate, and 2-propenoic acid, (1-methylethylidene) bis[4,1-phenyleneoxy (2-hydroxy-3,1-propanediyl)] (Ebecryl 3700). Particularly preferred examples of compounds that can be used as component C) are Ebecryl 3700, which is available from UCB Chemicals, and SR 399, which is available from the SARTOMER Company.

The preferred hybrid compositions contain at least 2 percent by weight of component (C) based on the overall composition. Preferably (C) is present in an amount of 3 to 30, particularly 5 to 25, more preferably 7 to 20, most preferably from 10 to 15% percent by weight based on the overall weight of the composition. When the amount of component (C) is not within the recited ranges, the composition fails to achieve miscibility and the interpenetrating network does not form as completely. Hence, one fails to see an improvement in physical properties as described in the description. The use of too much hydroxyacrylate is equally detrimental as that leads to reduced accuracy and reproducibility of prepared objects. Concurrently, the optimum ratio of hydroxy to epoxy is altered. Physical properties such as tensile strength, impact, and green strength are lessened.

The novel compositions optionally further comprise component (D) in a quantity of at least 5 percent by weight based on the overall quantity of the composition. In particular (D) is present in an amount of 7 to 35, preferably 10 to 30, more preferably 12 to 20 percent by weight.

Component (D) of the novel compositions is preferably selected from the group consisting of
(D1) the dihydroxybenzenes, trihydroxybenzenes and the compounds of the formula (D-I): 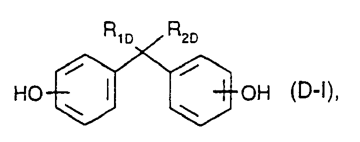 in which R_{1D} and R_{2D} are a hydrogen atom or a methyl group;
(D2) the compounds of the formula (D-II): 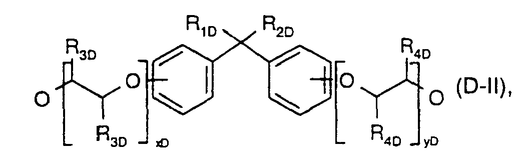
   in which R_{1D} and R_{2D} are each a hydrogen atom or a methyl group;
   R_{3D} and R_{4D} are all, independently of one another, a hydrogen atom or a methyl group, and
   xD and yD are each an integer from 1 to 15;
(D3) trimethylolpropane, glycerol, castor oil and the compounds of the formula (D-III) and (D-IV): 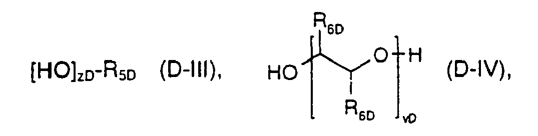
   in which R_{5D} is an unbranched or branched (zD)-valent C₂-C₂₀alkane residue, preferably a (zD)-valent C₂-C₆-alkane residue,
   all radicals R_{6D}, independently of one another, are a hydrogen atom or a methyl group,
   zD is an integer from 1 to 4 and
   vD is an integer from 2 to 20; and also
(D4) the compounds of the formulae (D-V), (D-VI), (D-VII), (D-VIII) (D-IX) and (D-X): 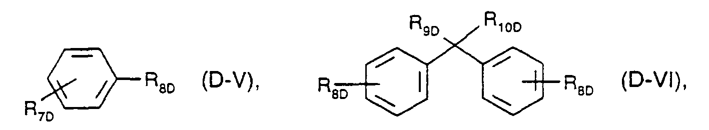 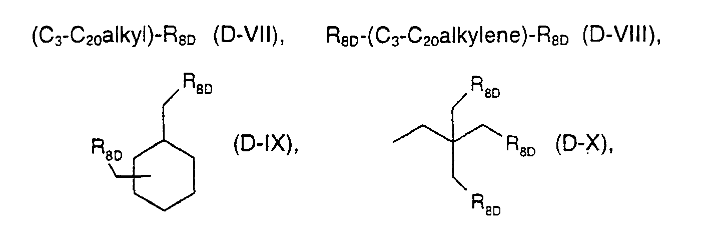 in which R_{7D}, R_{9D} and R_{10D} are each a hydrogen atom or a methyl group and each R_{8D} is a group selected from the groups of the formulae (D-XI), (D-XII), (D-XIII) and (D-XIV):

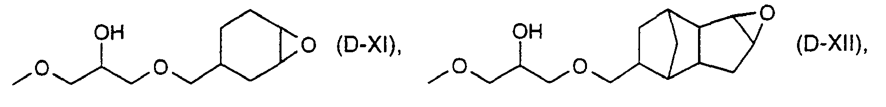

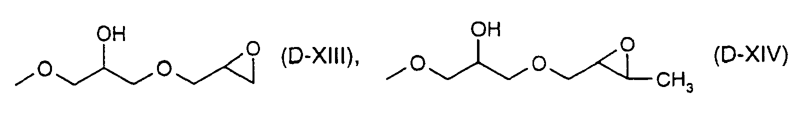

The compounds of the above formulae (D-I), (D-II), (D-V), (D-VI) and (D-IX) are preferably the respective 1,4 derivatives or bis-1,4 derivatives. The compounds of the formulae (D-I) to (D-X) and methods for their preparation are known to the person skilled in the art.

Component (D) of the novel compositions preferably consists of (D2) phenolic compounds having at least 2 hydroxyl groups which are reacted with ethylene oxide, propylene oxide or with ethylene oxide and propylene oxide, and especially of the compounds of the formula (D-IIa): 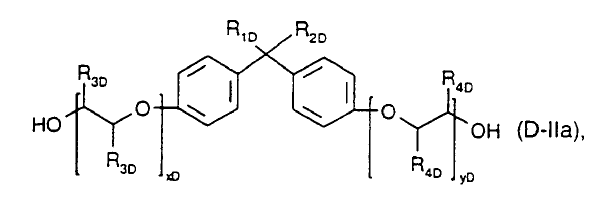
in which R_{1D} and R_{2D} are both a hydrogen atom or both a methyl group;
R_{3D} and R_{4D} are all, independently of one another, each a hydrogen atom or a methyl group, and
xD and yD are each an integer from 1 to 15.

The liquid poly(meth)acrylates having a (meth)acrylate functionality of more than two which are used in the novel compositions as component (E) may, for example, be tri-, tetra- or pentafunctional monomeric or oligomeric aliphatic, cycloaliphatic or aromatic acrylates or methacrylates. The compounds preferably have a molecular weight of from 200 to 500. The compounds of component (E) do not contain hydroxyl groups in their molecule.

Examples of suitable aliphatic polyfunctional (meth)acrylates are the triacrylates and trimethacrylates of hexane-2,4,6-triol, glycerol or 1,1,1-trimethylolpropane, ethoxylated or propoxylated glycerol or 1,1,1-trimethylolpropane.

It is additionally possible, for example, to use polyfunctional urethane acrylates or urethane methacrylates. These urethane (meth)acrylates are known to the person skilled in the art and can be prepared in a known manner by, for example, reacting a hydroxyl-terminated polyurethane with acrylic acid or methacrylic acid, or by reacting an isocyanate-terminated prepolymer with hydroxyalkyl (meth)acrylates to give the urethane (meth)acrylate.

The (meth)acrylates employed as component (E) are known compounds and some are commercially available, for example from the SARTOMER Company. Preferred compositions are those in which component (E) is a tri(meth)acrylate or a penta(meth)acrylate.

Examples of di(meth)acrylates that do not have hydroxyl groups in their molecule and which can be employed as component (F) are compounds of the formula (F-I), (F-II) and (F-III): 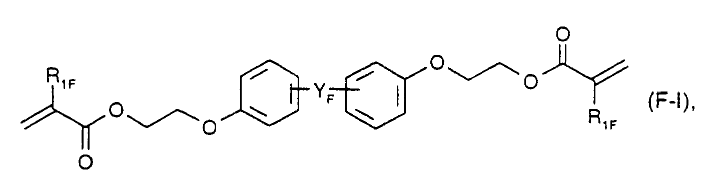 in which
- R_{1F}: is a hydrogen atom or methyl,
- Y_{F}: is a direct bond, C₁-C₆alkylene, -S-, -O-, -SO-, -SO₂- or -CO-;

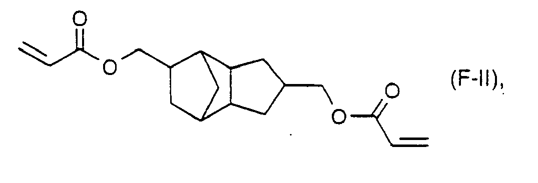

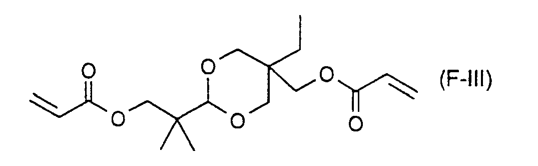

These compounds of the formulae (F-I) to (F-III) are known and some are commercially available. Their preparation is also described in U.S. Pat. No. 5,605,941.

In many cases it is also expedient to add further constituents to the novel compositions, examples being customary additives, such as reactive diluents, for example propylene carbonate, propylene carbonate propenyl ether or lactones, stabilizers, for example, UV stabilizers, polymerization inhibitors, release agents, wetting agents, leveling agents, sensitizers, antisettling agents, surface-active agents, dyes, pigments or fillers. Each of these is employed in a quantity effective for the desired purpose, and together they make up preferably up to 20 percent by weight of the novel compositions. Fillers in particular, however, may also be sensibly employed in greater quantities, for example in quantities of up to 75 percent by weight.

Particularly preferred novel compositions are those in which both component (A) and component (D) comprise substances having aliphatic carbon rings in their molecule. In such compositions, component (A) preferably contains one or more cycloaliphatic glycidyl ethers, especially diglycidyl ethers based on cycloaliphatic or polyethers, and mixtures of such diglycidyl ethers.

Particularly good properties are obtained by novel compositions comprising:
(A1) 20 to 60 percent by weight of an aromatic difunctional or more highly functional polyglycidyl ether or of a liquid mixture consisting of aromatic difunctional or more highly functional polyglycidyl ethers;
(A2) 0 to 50 percent by weight of an aliphatic or cycloaliphatic difunctional or more highly functional glycidyl ether;
(B) 0.1 to 10 percent by weight of a cationic photoinitiator or of a mixture of cationic photoinitiators; and
(C) 3 to 30, preferably 7 to 20, percent by weight of a compound or mixture of compounds having a terminal and/or pendant unsaturated group and hydroxyl group in its molecule;
(D) 5 to 40 percent by weight of a cycloaliphatic compound having at least 2 hydroxyl groups and/or of a cycloaliphatic compound having at least 2 hydroxyl groups which are reacted with ethylene oxide, propylene oxide or with ethylene oxide and propylene oxide;
(E) 4 to 30 percent by weight of at least one liquid poly(meth)acrylate having a (meth)acrylate functionality of more than 2,
(F) 0 to 20 percent by weight of one or more di(meth)acrylates and
(G) 0 to 10 percent by weight of a reactive diluent
wherein the sum of components (A), (B), (C), (D), (E), (F) and (G) is 100 percent by weight, and components (C), (D), (E), (F) and (G) are different, and
the composition contains no free radical initiator.

A further particularly preferred composition according to the invention comprises:
(A) 40 to 80 percent by weight of an aliphatic and/or cycloaliphatic difunctional or more highly functional glycidyl ether or of a mixture of such resins;
(B) 2 to 7 percent by weight of a cationic photoinitiator or of a mixture of cationic photoinitiators, particularly of a sulfonium type photoinitiator;
(C) 3 to 30, preferably 7 to 20, percent by weight of a compound or mixture of compounds having at least three unsaturated groups and a hydroxyl group in its molecule;
(D) 10 to 20 percent by weight of a cycloaliphatic compound having at least 2 hydroxyl groups which is reacted with ethylene oxide, with propylene oxide or with ethylene oxide and propylene oxide;
(E) 4 to 10 percent by weight of at least one liquid poly(meth)acrylate having a (meth)acrylate functionality of more than 2, and
(F) 4 to 10 percent by weight of one or more di(meth,)acrylates,
wherein the sum of components (A), (B), (C), (D), (E) and(F) is 100 percent by weight, and components (C), (D), (E) and(F) are different, and
the composition contains no free radical initiator.

The novel compositions can be prepared in a known manner by, for example, premixing individual components and then mixing these premixes, or by mixing all of the components using customary devices, such as stirred vessels, in the absence of light and, if desired, at slightly elevated temperature.

The novel compositions can be polymerized by irradiation with actinic light, for example by means of electron beams, X-rays, UV or VIS light, preferably with radiation in the wavelength range of 280-1170 nm. Particularly suitable are laser beams of HeCd, argon or nitrogen and also metal vapor and NdYAG lasers. The person skilled in the art is aware that it is necessary, for each chosen light source, to select the appropriate photoinitiator and, if appropriate, to carry out sensitization. It has been recognized that the depth of penetration of the radiation into the composition to be polymerized, and also the operating rate, are directly proportional to the absorption coefficient and to the concentration of the photoinitiator.

The invention additionally relates to a method of producing a cured product, in which compositions as described above are treated with actinic radiation. For example, it is possible in this context to use the novel compositions as adhesives, as coating compositions, as photoresists, for example as solder resists, or for rapid prototyping, but especially for stereolithography. When the novel mixtures are employed as coating compositions, the resulting coatings on wood, paper, metal, ceramic or other surfaces are clear and hard. The coating thickness may vary greatly and can for instance be from 0.01 mm to about 1 mm. Using the novel mixtures it is possible to produce relief images for printed circuits or printing plates directly by irradiation of the mixtures, for example by means of a computer-controlled laser beam of appropriate wavelength or employing a photomask and an appropriate light source.

One specific embodiment of the abovementioned method is a process for the stereolithographic production of a three-dimensional shaped article, in which the article is built up from a novel composition with the aid of a repeating, alternating sequence of steps (a) and (b); in step (a), a layer of the composition, one boundary of which is the surface of the composition, is cured with the aid of appropriate radiation within a surface region which corresponds to the desired cross-sectional area of the three-dimensional article to be formed, at the height of this layer, and in step (b) the freshly cured layer is covered with a new layer of the liquid, radiation-curable composition, this sequence of steps (a) and (b) being repeated until an article having the desired shape is formed. In this process, the radiation source used is preferably a laser beam, which with particular preference is computer-controlled.

In general, the above-described initial radiation curing, in the course of which the so-called green models are obtained which do not as yet exhibit adequate strength, is followed then by the final curing of the shaped articles by heating and/or further irradiation.

The term "liquid" in this application is to be equated with "liquid at room temperature" in the absence of any statement to the contrary, room temperature being understood as being, in general, a temperature between 5° and 40°C, preferably between 10° and 30°C.

### Examples:

The trade names of the components as indicated in the examples below correspond to the chemical substances as defined in the following table.

| Trade name | Chemical designation |
|---|---|
| Araldit CY 179 | 3,4-epoxycyclohexylmethyl 3',4'-epoxycyclohexanecarboxylate |
| Araldit DY 026 | butanediol diglycidyl ether |
| Araldit DY 0396 | cyclohexanedimethanol diglycidyl ether |
| Araldit GY 250 | bisphenol A diglycidyl ether |
| Cyracure | mixture of (C₆H₅)S(C₆H₄)-S⁺(C₆H₅)₂SbF₆⁻ and |
| UVI 6974 | F₆Sb⁻(C₆H₅)₂S⁺-(C₆H₄)S(C₆H₄)-S⁺(C₆H₄)₂SbF₆⁻ |
| Ebecryl 3700 | 2-Propenoic acid, (1-methylethylidene) bis[4,1-phenyleneoxy (2-hydroxy-3,1-propanediyl)] |
| ERL 4221 | 3,4-Epoxycyclohexylmethyl 3,4-epoxycyclohexanecarboxylate |
| Irgacure 184 | 1-hydroxycyclohexyl phenyl ketone |
| Sartomer SR 295 | Pentaerythritol tetraacrylate |
| Sartomer SR 349 | Bisphenol A bis(2-hydroxyethyl ether) diacrylate |
| Sartomer SR 399 | dipentaerythritol monohydroxypentaacrylate |
| Sartomer SR 9041 | |
| Tone 0301 | Polycapralactone triol |
| UVR 6105 | 3,4-Epoxycyclohexyimethyl 3,4-epoxycyclohexanecarboxylate |

The formulations indicated in the examples are prepared by mixing the components, with a stirrer at 20°C, until a homogeneous composition is obtained. The physical data relating to the formulations are obtained as follows:

The viscosity of the liquid mixture is determined at 25°C using a Brookfield viscometer.

The mechanical properties of the formulations are determined on three-dimensional specimens produced with the aid of an He/Cd, Ar/UV, or NdYAG laser.

The photosensitivity of the formulations is determined on so-called window panes. In this determination, single-layer test specimens are produced using different laser energies, and the layer thicknesses obtained are measured. The plotting of the resulting layer thickness on a graph against the logarithm of the irradiation energy used gives a "working curve". The slope of this curve is termed Dₚ (given in mm or mils). The energy value at which the curve passes through the x-axis is termed E_{c} (and is the energy at which gelling of the material still just takes place; cf. P. Jacobs, Rapid Prototyping and Manufacturing, Soc. of Manufacturing Engineers, 1992, p. 270 ff.).

The green strength is determined by measuring the flexural modulus 10 minutes and 1 hour after production of the test specimen (ASTM D 790). The flexural modulus after curing is determined after the test specimen has been cured in UV light for 1.5 hours.

Examples 1-8: The mixtures are prepared as described above. Their compositions and physical properties can be taken from the table below.

**Table 1.**

| Type / Component | Ex. 1 | Ex. 2 | Ex. 3 | Ex. 4 | Ex. 5 | Ex. 6 | Ex. 7 | Ex. 8 |
|---|---|---|---|---|---|---|---|---|
| (A) ERL 4221 | | | 31.4 | 31.4 | 31.4 | 31.4 | 31.4 | 31.4 |
| (A) UVR 6105 | | | 16.8 | 16.8 | 16.8 | 16.8 | 16.8 | 16.8 |
| (A) DY 026 | 17.07 | 17.07 | 18.0 | 18.0 | 18.0 | 18.0 | 18.0 | 18.0 |
| (A) CY179 | 55.22 | 55.22 | | | | | | |
| (B) UVI-6974 | 1.0 | 2.01 | 0.8 | 0.8 | 0.8 | 1.2 | 0.8 | 1.2 |
| (B) I-184 | 1.0 | | 1.0 | 1.0 | 1.0 | | | |
| (C) SR 399 | 12.89 | 12.85 | 5.8 | 5.8 | | | 5.8 | 5.8 |
| (C) Ebecryl 3700 | | | | 6.4 | | | 6.4 | 6.4 |
| (D) TONE 0301 | 12.85 | 12.85 | 19.8 | 19.8 | 19.8 | 19.8 | 19.8 | 19.8 |
| (E) SR 295 | | | | | 5.8 | 5.8 | | |
| (F) SR 349 | | | 6.4 | | 6.4 | 6.4 | | |
| Total weight | 100.0 | 100.0 | 100.0 | 100.0 | 100.0 | 99.4 | 99.0 | 99.4 |
| Properties | | | | | | | | |
| Tensile Strength (psi) | NA | | 8112 | 8250 | 7759 | 6674 | 5728 | 7280 |
| Elongation at Break (%) | 4 | 2.4 | 5.7 | 5.8 | 5.1 | 3.7 | 1.7 | 2.8 |
| Impact Resistance (ft-b/in) | NA | NA | 0.7 | 0.7 | 0.8 | 0.4 | 0.8 | 0.8 |
| Dp (mils) | 2.16 | 2.88 | 4.3 | 4.35 | 4.37 | 5.27 | 2.63 | 5.39 |
| Dp (mm) | 0.05 | 0.07 | 0.11 | 0.11 | 0.11 | 0.13 | 0.07 | 0.14 |
| Ec (mj/cm2) | 2.5 | 33.86 | 8.63 | 10.66 | 8.87 | 12.1 | 4.93 | 13.43 |
| E11 | 407.0 | 1543. | 111.6 | 133.6 | 109.8 | 97.72 | 325.0 | 103.5 |
| FM @ 10 minutes | 35 | 1363 | 1680 | 1680 | 1834 | 1323 | 1623 | 1598 |
| FM @ 60 minutes | NA | NA | 1922 | 1818 | 2030 | 1488 | 1736 | 1617 |
| FM after 90 minutes UV | NA | NA | 2595 | 2636 | 2729 | 1822 | 2076 | 2719 |
| FM @ 14 days | NA | NA | 241 | 372 | 187 | 87 | 342 | 499 |
| CF 6 Aces (Specwall) | 0.09 | 0.05 | | NA | NA | NA | NA | NA |
| CF 11 Aces (Specwall) | 0.07 | 0.04 | | NA | NA | NA | NA | NA |
| Viscosity [cps (mPaS)] | NA | NA | 230 | 395 | 165 | NA | NA | 530 |
| Laser Used (nm) | 325 | 325 | 325 | 325 | 325 | 325 | 325 | 325 |

Examples 1 and 2 compare the performance of hybrid systems with and without free radical photoinitiator. The photospeed in the system of example 2 without the free radical initiator is more than 4 times slower (as indicated by E11 values) than the system with the free radical initiator.

The amount of hydroxy (meth)acrylate was varied in the systems of experiments 3-5 without removing free radical initiator. Substitutions of (meth)acrylates were as analogous as possible so that the only difference was the presence or absence of a hydroxyl group. There are no significant differences in the properties of the final cured articles.

The affect of eliminating free radical initiator in example 6, which contains no hydroxy (meth) acrylate, is a reduction in physical properties. Examples 5 and 6 are identical with the exception that example 5 contains free radical initiator. Without the free radical photoinitiator the tensile strength in example 6 was reduced. Impact dropped 50%. Flexural modulus was significantly impacted. The value for flexural modulus for example 6 after fourteen days in water was only a third of the value found in example 5.

Comparison of examples 4 and 7 highlight the similarities in physical properties resulting from the standard hybrid- and the new unique-polymerization systems. Example 4 contains free radical initiator while example 7 contains no free radical photoinitiator. The similarity in properties implies that the cationic initiator/hydroxy (meth)acrylate mechanism is significant and cure can occur even when the free radical initiator is not present.

Examples 7 and 8 contain the elements found in the unique stereolithography resins. They contain hydroxylated (meth)acrylates, cationically activated ring opening components, and are free of free radical photoinitiator. They can be compared directly to examples 4 and 6, respectively.

Example 4 is identical to example 7 except that it contains a free radical photoinitiator. While the free radical photoinitiator decreases the required exposure for a given part, the properties of the models are similar except that the flexural modulus of example 4 is improved over example 7. A similar cure was achieved even in the absence of a free radical photoinitiator. Example 8 provides a better comparison to 4 by adjusting the photospeed to be closer to the measured photospeed for the system in example 4. The physical properties measured for examples 4 and 8 are similar.

Example 6 is identical to example 8 with the exception that example 6 does not contain the hydroxy-acrylates required to give the unique stereolithographic resin. The result is that the properties of example 8 are superior to example 6. Example 8 has the same build speed, an impact strength that is twice the value for example 6, and enhanced flexural modulus of the green and cured parts.

## Claims

1. A liquid, radiation-curable composition comprising:
a) 40 to 80 percent by weight of a liquid component consisting of one or more than one polyfunctional compound having at least two groups capable of reacting via or as a result of a ring-opening mechanism to form a polymeric network,
b) 0.1 to 10 percent by weight of a cationic photoinitiator or a mixture of cationic photoinitiators,
c) 2 to 30 percent by weight of a compound having at least one unsaturated group and at least one hydroxy group in its molecule,
d) 0 to 40 percent by weight of a hydroxy compound having no unsaturated groups,
e) 0 to 30 percent by weight of at least one liquid poly(meth)acrylate having a functionality of more than 2 and having no hydroxy groups,
f) 0 to 40 percent by weight of at least one liquid cycloaliphatic or aromatic di(meth)acrylate having no hydroxy groups, and
g) 0 to 10 percent by weight of a reactive diluent,
wherein the sum of components a), b), c), d), e), f) and g) is 100 percent by weight, and components c), d), e), f) and g) are different, and
the composition contains no free radical initiator.

2. A composition according to claim 1, which contains 50 to 80, preferably 60 to 80, more preferably 65 to 80 percent by weight of component a).

3. A composition according to claim 1, which contains 0.5 to 6, preferably 0.5 to 3, more preferably 1.0 to 1.5 percent by weight of component b).

4. A composition according to claim 1, which contains 5 to 25, preferably 7 to 20, more preferably 10 to 15 percent by weight of component c).

5. A composition according to claim 1, which contains 5 to 40, preferably 7 to 35, more preferably 10 to 30, most preferably 12 to 20 percent by weight of component d).

6. A composition according to claim 1, which contains 4 to 30 percent by weight of component e).

7. A composition according to claim 1 or claim 6, wherein component e) is not more than 50 percent by weight of the entire (meth)acrylate content.

8. A composition according to claim 1, which contains 5 to 40 percent by weight of component f).

9. A composition according to claim 1, wherein component (a) contains oxirane (epoxide) rings in the molecule.

10. A composition according to claim 1 comprising
a1) 20 to 60 percent by weight of an aromatic difunctional or more highly functional polyglycidyl ether or of a liquid mixture consisting of aromatic difunctional or more highly functional polyglycidyl ethers,
a2) 0 to 50 percent by weight of an aliphatic or cycloaliphatic glycidyl ether,
c) 3 to 30 percent by weight of a compound or mixture of compounds having at least three unsaturated groups and a hydroxyl group in its molecule,
d) 5 to 40 percent by weight of a cycloaliphatic compound having at least 2 hydroxyl groups and/or of a cycloaliphatic compound having at least 2 hydroxyl groups which is reacted with ethylene oxide, propylene oxide or with ethylene oxide and propylene oxide,
e) 4 to 30 percent by weight of at least one liquid poly(meth)acrylate having a (meth)acrylate functionality of more than 2,
f) 0 to 20 percent by weight of one or more di(meth)acrylates.

11. A composition according to claim 1, comprising:
a) 40 to 80 percent by weight of an aliphatic and/or cycloaliphatic difunctional or more highly functional glycidyl ether or of a mixture of such resins,
b) 2 to 7 percent by weight of a cationic photoinitiator or of a mixture of cationic photoinitiators,
c) 3 to 30 percent by weight of a compound or mixture of compounds having at least three unsaturated groups and a hydroxyl group in its molecule,
d) 10 to 20 percent by weight of a phenolic compound having at least 2 hydroxyl groups which is reacted with ethylene oxide, with propylene oxide or with ethylene oxide and propylene oxide,
e) 4 to 10 percent by weight of at least one liquid poly(meth)acrylate having a (meth)acrylate functionality of more than 2, and
f) 4 to 10 percent by weight of one or more di(meth)acrylates.

12. A composition according to claim 1 wherein component c) contains a compound selected from the group consisting of
i) hydroxyl-containing (meth)acrylates of the formulae 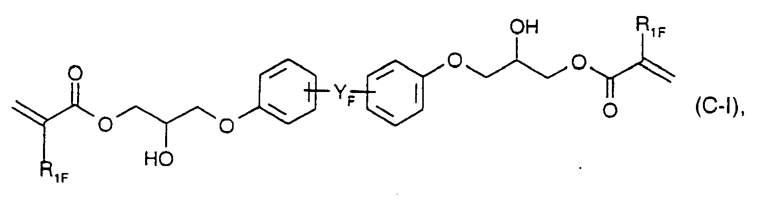 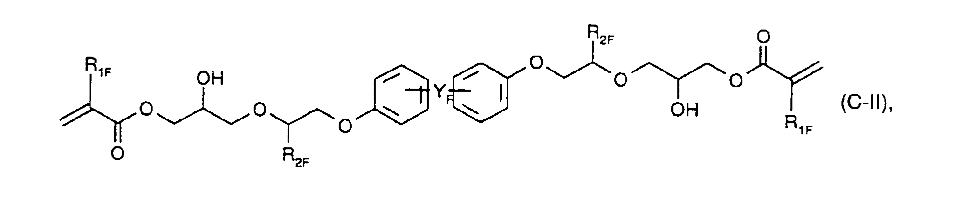 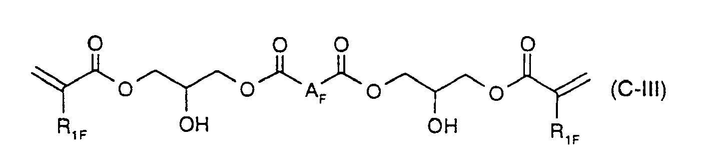 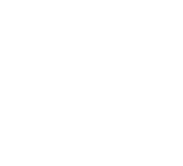 in which
R_{1F} is a hydrogen atom or methyl,
Y_{F} is a direct bond, C₁-C₆alkylene, -S-, -O-, -SO-, -SO₂- or -CO-,
R_{2F} is a C₁-C₈alkyl group, a phenyl group which is unsubstituted or substituted by one or more C₁-C₄alkyl groups, hydroxyl groups or halogen atoms, or is a radical of the formula -CH₂-OR_{3F} in which R_{3F} is a C₁-C₈alkyl group or phenyl group, and
A_{F} is a radical selected from the radicals of the formulae 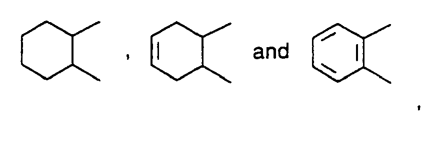 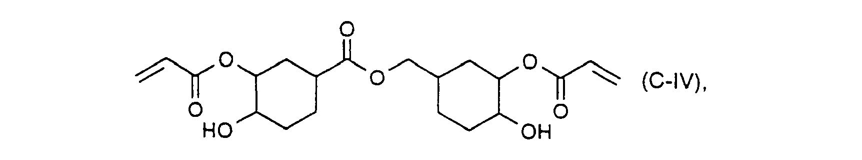 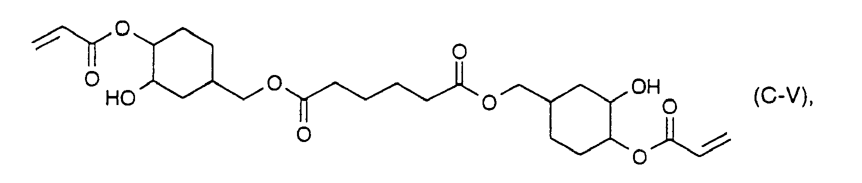
ii) hydroxyl-containing (meth)acrylates according to the formula 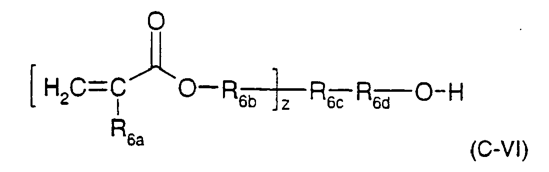 wherein R₆ₐ is H or C₁-C₄alkyl, R_{6b} and R_{6d} are, independently of one another divalent linear or branched linking groups having 1 to 20 carbon atoms that are optionally substituted one or more times with C₁-C₄alkyl, hydroxyl or interrupted one or more times by a carbonyl group, R₆, is a multi-valent linear or branched group having 1 to 4 carbon atoms, z is an integer from 1 to 3,
or according to the formula 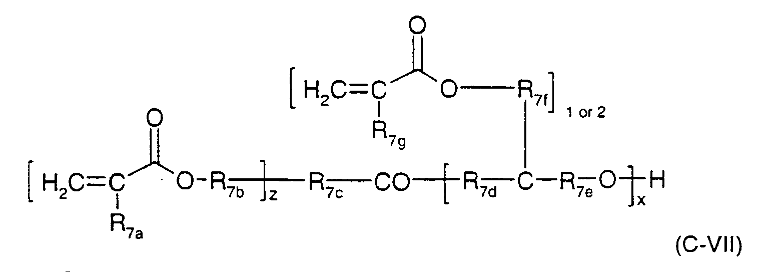 wherein R₇ₐ and R₇₉ are independently of one another H or C₁-C₄alkyl, R_{7c} is a multi-valent group having 1 to 4 carbon atoms, R_{7b}, R_{7d}, R₇ₑ and R_{7f} are, independently of one another, divalent linear or branched radicals having 1 to 20 carbon atoms that are optionally substituted one or more times with C₁-C₄alkyl, hydroxyl or interrupted one or more times by a carbonyl group, x is an integer from 1 to 4 and z is an integer from 1 to 3,
or according to the formula 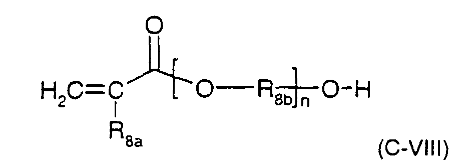 wherein R₈ₐ is H or C₁-C₄alkyl and R_{8b} is a divalent linear or branched group having 2 to 6 carbon atoms,
or according to the formula 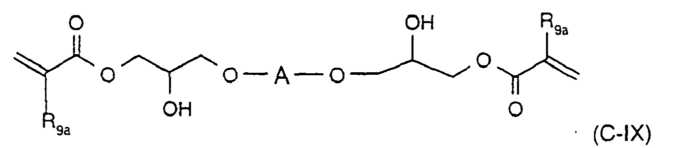 wherein R₉ₐ is H or C₁-C₄alkyl and A is a divalent linear or branched linking group having 2 to 10 carbon atoms,
iii) hydroxyl-containing vinyl ethers according to the formulae 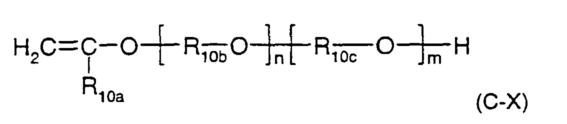 wherein x and y are integers from 0 to 20, R₁₀ₐ is H or C₁-C₄alkyl, R_{10b} is an aliphatic group having 3 to 10 carbon atoms, R_{10c} is a cycloaliphatic, aromatic, aliphatic-aromatic or aliphatic-cycloaliphatic group having 5 to 24 carbon atoms, n is an integer from 0 to 5 and m is an integer from 0 to 5, and
iv) hydroxyl-containing poly(meth)acrylates obtained by replacing at least some of the available hydroxyl groups of the compounds of formula (C-I) to (C-IX) with epoxy groups.

13. A composition according to claim 1 wherein component c) contains at least one compound according to formula 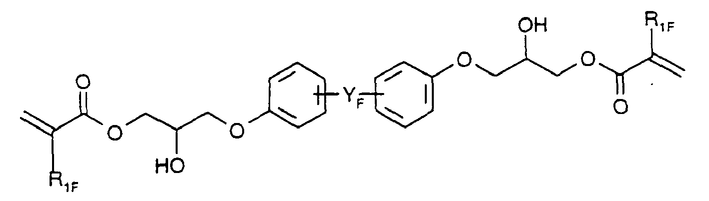 wherein R_{1F} is hydrogen and Y_{F} is -C(CH₃)₂-.

14. A composition according to claim 1 wherein component c) contains at least one compound according to formula 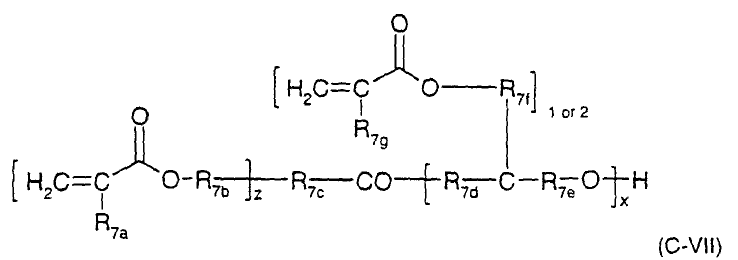
wherein R₇ₐ and R_{7g} are H, R_{7b}, R_{7d}, R₇ₑ and R_{7f} are methylene groups, R_{7c} is C,
z is 3 and x is 1.

15. A composition according to claim 1 wherein component c) contains a compound or mixture of compounds having more than one unsaturated group per molecule.

16. A composition according to claim 1, in which component d) consists of phenolic compounds having at least 2 hydroxyl groups which are reacted with ethylene oxide, propylene oxide or with ethylene oxide and propylene oxide.

17. A method of producing a cured product, in which a composition according to any one of claims 1 to 16 is treated with actinic radiation.

18. A method for producing a three-dimensional shaped article in which the article is built up from a composition according to any one of claims 1 to 16 with the aid of a repeating, alternating sequence of steps (a) and (b), in step (a), a layer of the composition according to any of claims 1 to 16, one boundary of which is the surface of the composition, is cured with the aid of appropriate radiation within a surface region which corresponds to the desired cross-sectional area of the three-dimensional article to be formed, at the height of this layer, and in step (b) the freshly cured layer is covered with a new layer of the radiation-curable, liquid composition, this sequence of steps (a) and (b) being repeated until an article having the desired shape is formed and this article is, if desired, subjected to post-curing.

## Patentansprüche

1. Flüssige strahlungshärtbare Harzzusammensetzung, umfassend:
a) 40 bis 80 Gew.-% einer flüssigen Komponente, die aus einer oder mehr als einer polyfunktionellen Verbindung besteht, die wenigstens zwei Gruppen aufweist, die über einen oder als Ergebnis eines Ringöffnungsmechanismus unter Bildung eines polymeren Netzwerks reagieren können;
b) 0,1 bis 10 Gew.-% eines kationischen Photoinitiators oder eines Gemischs von kationischen Photoinitiatoren;
c) 2 bis 30 Gew.-% einer Verbindung, die wenigstens eine ungesättigte Gruppe und wenigstens eine Hydroxygruppe in ihrem Molekül aufweist;
d) 0 bis 40 Gew.-% einer Hydroxyverbindung, die keine ungesättigten Gruppen aufweist;
e) 0 bis 30 Gew.-% wenigstens eines flüssigen Poly(meth)acrylats mit einer Funktionalität von mehr als 2 und ohne Hydroxygruppen;
f) 0 bis 40 Gew.-% wenigstens eines flüssigen cycloaliphatischen oder aromatischen Di(meth)acrylats ohne Hydroxygruppen; und
g) 0 bis 10 Gew.-% eines reaktiven Verdünnungsmittels;
wobei die Summe der Komponenten a), b), c), d), e), f) und g) 100 Gew.-% beträgt und die Komponenten c), d), e), f) und g) verschieden sind; und
die Zusammensetzung keinen Radikalstarter enthält.

2. Zusammensetzung gemäß Anspruch 1, die 50 bis 80, vorzugsweise 60 bis 80, besonders bevorzugt 65 bis 80, Gew.-% Komponente a) enthält.

3. Zusammensetzung gemäß Anspruch 1, die 0,5 bis 6, vorzugsweise 0,5 bis 3, besonders bevorzugt 1,0 bis 1,5, Gew.-% Komponente b) enthält.

4. Zusammensetzung gemäß Anspruch 1, die 5 bis 25, vorzugsweise 7 bis 20, besonders bevorzugt 10 bis 15, Gew.-% Komponente c) enthält.

5. Zusammensetzung gemäß Anspruch 1, die 5 bis 40, vorzugsweise 7 bis 35, besonders bevorzugt 10 bis 30, am meisten bevorzugt 12 bis 20, Gew.-% Komponente d) enthält.

6. Zusammensetzung gemäß Anspruch 1, die 4 bis 30 Gew.-% Komponente e) enthält.

7. Zusammensetzung gemäß Anspruch 1 oder 6, wobei Komponente e) nicht mehr als 50 Gew.-% des gesamten (Meth)acrylat-Gehalts ausmacht.

8. Zusammensetzung gemäß Anspruch 1, die 5 bis 40 Gew.-% Komponente f) enthält.

9. Zusammensetzung gemäß Anspruch 1, wobei Komponente a) Oxiranringe (Epoxidgruppen) im Molekül enthält.

10. Zusammensetzung gemäß Anspruch 1, umfassend:
a1) 20 bis 60 Gew.-% eines aromatischen difunktionellen oder höherfunktionellen Polyglycidylethers oder eines flüssigen Gemischs, das aus aromatischen difunktionellen oder höherfunktionellen Polyglycidylethern besteht;
a2) 0 bis 50 Gew.-% eines aliphatischen oder cycloaliphatischen Glycidylethers;
c) 3 bis 30 Gew.-% einer Verbindung oder eines Gemischs von Verbindungen, die wenigstens drei ungesättigte Gruppen und eine Hydroxygruppe in ihrem Molekül aufweist;
d) 5 bis 40 Gew.-% einer cycloaliphatischen Verbindung, die wenigstens 2 Hydroxygruppen aufweist, und/oder einer cycloaliphatischen Verbindung, die wenigstens 2 Hydroxygruppen aufweist und mit Ethylenoxid, Propylenoxid oder mit Ethylenoxid und Propylenoxid umgesetzt ist;
e) 4 bis 30 Gew.-% wenigstens eines flüssigen Poly(meth)acrylats mit einer (Meth)acrylat-Funktionalität von mehr als 2;
f) 0 bis 20 Gew.-% eines oder mehrerer Di(meth)acrylate.

11. Zusammensetzung gemäß Anspruch 1, umfassend:
a) 40 bis 80 Gew.-% eines aliphatischen und/oder cycloaliphatischen difunktionellen oder höherfunktionellen Glycidylethers oder eines Gemischs solcher Harze;
b) 2 bis 7 Gew.-% eines kationischen Photoinitiators oder eines Gemischs von kationischen Photoinitiatoren;
c) 3 bis 30 Gew.-% einer Verbindung oder eines Gemischs von Verbindungen, die wenigstens drei ungesättigte Gruppen und eine Hydroxygruppe in ihrem Molekül aufweist;
d) 10 bis 20 Gew.-% einer phenolischen Verbindung, die wenigstens 2 Hydroxygruppen aufweist und mit Ethylenoxid, Propylenoxid oder mit Ethylenoxid und Propylenoxid umgesetzt ist;
e) 4 bis 10 Gew.-% wenigstens eines flüssigen Poly(meth)acrylats mit einer (Meth)acrylat-Funktionalität von mehr als 2; und
f) 4 bis 10 Gew.-% eines oder mehrerer Di(meth)acrylate.

12. Zusammensetzung gemäß Anspruch 1, wobei Komponente c) eine Verbindung enthält, die aus der Gruppe ausgewählt ist, die aus Folgenden besteht:
i) hydroxylhaltige (Meth)acrylate der Formeln 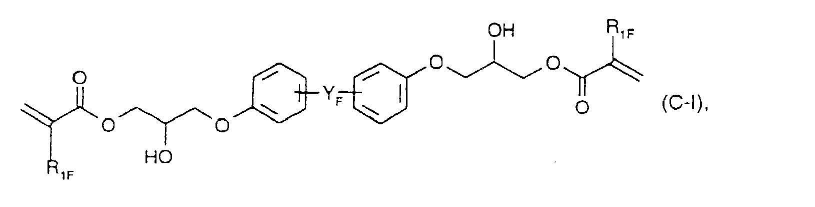 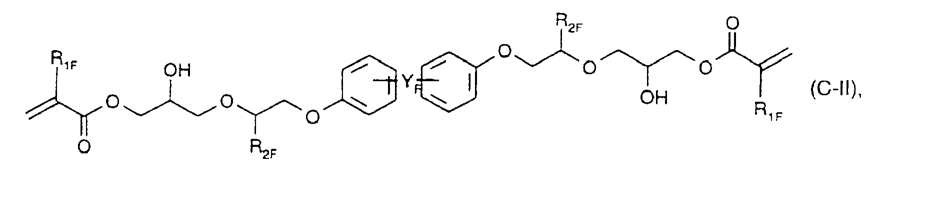 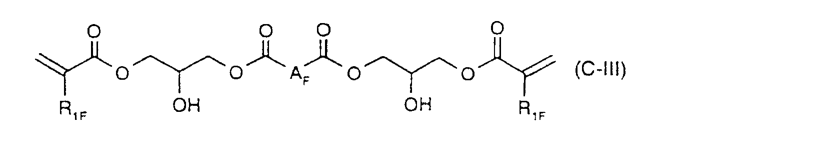 wobei
R_{1F} ein Wasserstoffatom oder Methyl ist;
Y_{F} eine direkte Bindung, C₁-C₆-Alkylen, -S-, -O-, -SO-, -SO₂- oder -CO- ist;
R_{2F} eine C₁-C₈-Alkylgruppe, eine Phenylgruppe, die unsubstituiert oder mit einer oder mehreren C₁-C₄-Alkylgruppen, Hydroxygruppen oder Halogenatomen substituiert ist, oder ein Rest der Formel -CH₂-OR_{3F} ist, wobei R_{3F} eine C₁-C₈- Alkylgruppe oder Phenylgruppe ist; und
A_{F} ein Rest ist, der aus den Resten der Formeln 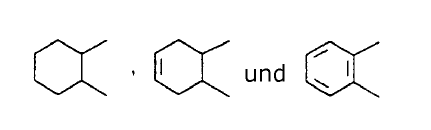
ausgewählt ist; 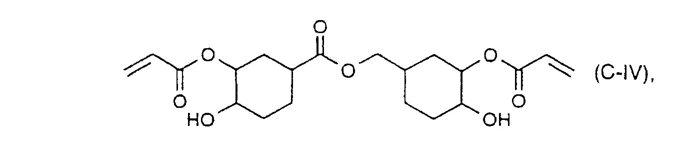 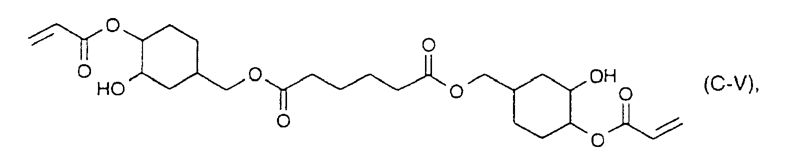
ii) hydroxylhaltige (Meth)acrylate gemäß der Formel 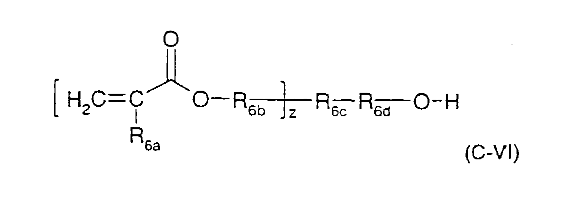 wobei R₆ₐ = H oder C₁-C₄-Alkyl ist, R_{6b} und R_{6d} unabhängig voneinander zweiwertige lineare oder verzweigte Verknüpfungsgruppen mit 1 bis 20 Kohlenstoffatomen sind, die gegebenenfalls einfach oder mehrfach mit C₁-C₄-Alkyl oder Hydroxy substituiert sind oder einfach oder mehrfach durch eine Carbonylgruppe unterbrochen sind, R_{6c} eine mehrwertige lineare oder verzweigte Gruppe mit 1 bis 4 Kohlenstoffatomen ist, z eine ganze Zahl von 1 bis 3 ist;
oder gemäß der Formel 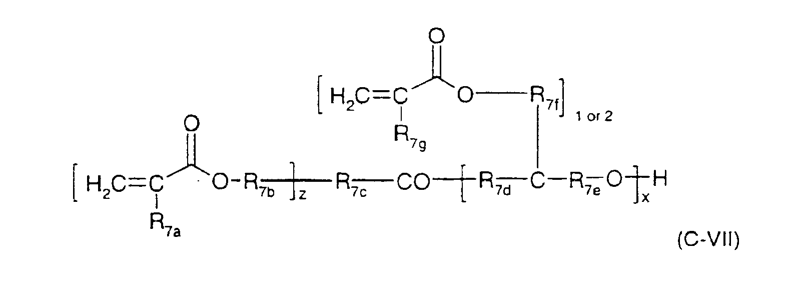 wobei R₇ₐ und R₇₉ unabhängig voneinander H oder C₁-C₄-Alkyl sind, R_{7c} eine mehrwertige Gruppe mit 1 bis 4 Kohlenstoffatomen ist, R_{7b}, R_{7d}, R₇ₑ und R_{7f} unabhängig voneinander zweiwertige lineare oder verzweigte Reste mit 1 bis 20 Kohlenstoffatomen sind, die gegebenenfalls einfach oder mehrfach mit C₁-C₄-Alkyl oder Hydroxy substituiert sind oder einfach oder mehrfach durch eine Carbonylgruppe unterbrochen sind, x eine ganze Zahl von 1 bis 4 ist und z eine ganze Zahl von 1 bis 3 ist;
oder gemäß der Formel 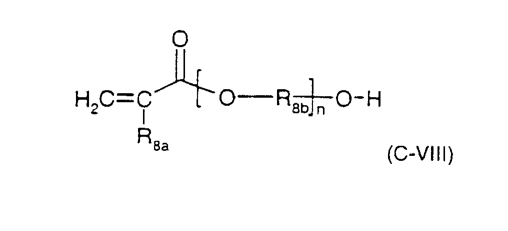 wobei R₈ₐ = H oder C₁-C₄-Alkyl ist und R_{8b} eine zweiwertige lineare oder verzweigte Gruppe mit 2 bis 6 Kohlenstoffatomen ist;
oder gemäß der Formel 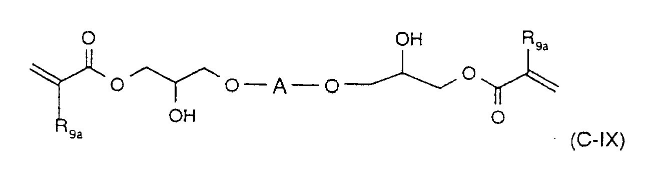 wobei R₉ₐ = H oder C₁-C₄-Alkyl ist und A eine zweiwertige lineare oder verzweigte Verknüpfungsgruppe mit 2 bis 10 Kohlenstoffatomen ist;
iii) hydroxylhaltige Vinylether gemäß den Formeln 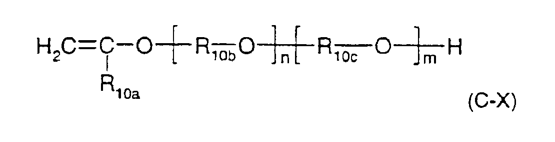 wobei x und y ganze Zahlen von 0 bis 20 sind, R₁₀ₐ = H oder C₁-C₄-Alkyl ist, R_{10b} eine aliphatische Gruppe mit 3 bis 10 Kohlenstoffatomen ist, R_{10c} eine cycloaliphatische, aromatische, aliphatisch-aromatische oder aliphatisch-cycloaliphatische Gruppe mit 5 bis 24 Kohlenstoffatomen ist, n eine ganze Zahl von 0 bis 5 ist und m eine ganze Zahl von 0 bis 5 ist; und
iv) hydroxylhaltige Poly(meth)acrylate, die man erhält, indem man wenigstens einige der verfügbaren Hydroxygruppen der Verbindungen der Formel (C-I) bis (C-IX) durch Epoxygruppen ersetzt.

13. Zusammensetzung gemäß Anspruch 1, wobei Komponente c) wenigstens eine Verbindung gemäß der Formel 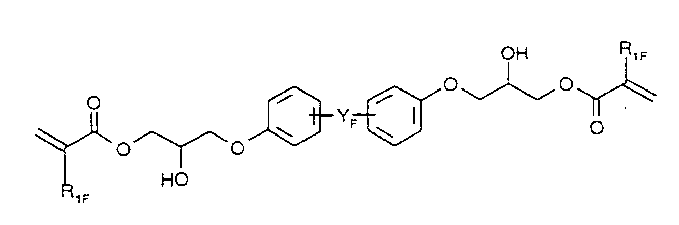 enthält, wobei R_{1F} Wasserstoff ist und Y_{F} = -C(CH₃)₂- ist.

14. Zusammensetzung gemäß Anspruch 1, wobei Komponente c) wenigstens eine Verbindung gemäß der Formel 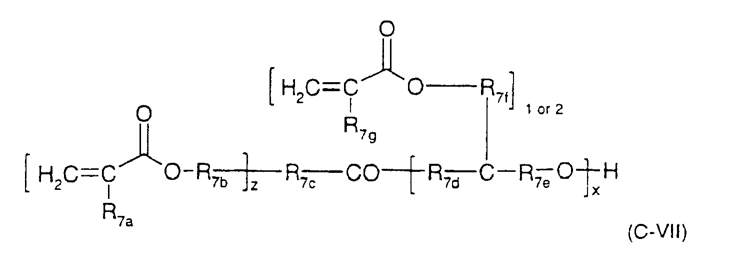 enthält, wobei R₇ₐ und R_{7g} = H sind, R_{7b}, R_{7d}, R₇ₑ und R_{7f} Methylengruppen sind, R_{7c} = C ist, z = 3 ist und x = 1 ist.

15. Zusammensetzung gemäß Anspruch 1, wobei Komponente c) eine Verbindung oder ein Gemisch von Verbindungen, die mehr als eine ungesättigte Gruppe pro Molekül aufweisen, enthält.

16. Zusammensetzung gemäß Anspruch 1, wobei Komponente d) aus phenolischen Verbindungen besteht, die wenigstens 2 Hydroxygruppen aufweisen, die mit Ethylenoxid, Propylenoxid oder mit Ethylenoxid und Propylenoxid umgesetzt sind.

17. Verfahren zur Herstellung eines gehärteten Produkts, wobei eine Zusammensetzung gemäß einem der Ansprüche 1 bis 16 mit aktinischer Strahlung behandelt wird.

18. Verfahren zur Herstellung eines dreidimensionalen geformten Artikels, wobei der Artikel mit Hilfe einer sich wiederholenden alternierenden Abfolge der Schritte (a) und (b) aus einer Zusammensetzung gemäß einem der Ansprüche 1 bis 16 aufgebaut wird, in Schritt (a) eine Schicht aus der Zusammensetzung gemäß einem der Ansprüche 1 bis 16, deren eine Grenze die Oberfläche der Zusammensetzung ist, mit Hilfe von geeigneter Strahlung innerhalb eines Oberflächenbereichs, der der gewünschten Querschnittsfläche des zu bildenden dreidimensionalen Artikels auf der Höhe dieser Schicht entspricht, gehärtet wird und in Schritt (b) die frisch gehärtete Schicht mit einer neuen Schicht der strahlungshärtbaren flüssigen Zusammensetzung bedeckt wird, wobei diese Abfolge der Schritte (a) und (b) so oft wiederholt wird, bis ein Artikel mit der gewünschten Form gebildet ist, und dieser Artikel gegebenenfalls einer Nachhärtung unterzogen wird.

## Revendications

1. Composition durcissable par rayonnement, liquide, comprenant :
a) 40 à 80 pour cent en poids d'un composant liquide consistant en un ou plus d'un composé polyfonctionnel ayant au moins deux groupes capables de réagir par l'intermédiaire de ou par suite d'un mécanisme d'ouverture de cycle pour former un réseau polymère ;
b) 0,1 à 10 pour cent en poids d'un photoinitiateur cationique ou d'un mélange de photoinitiateurs cationiques ;
c) 2 à 30 pour cent en poids d'un composé ayant au moins un groupe insaturé et au moins un groupe hydroxy dans sa molécule ;
d) 0 à 40 pour cent en poids d'un composé hydroxy n'ayant pas de groupes insaturés ;
e) 0 à 30 pour cent en poids d'au moins un poly(méth)acrylate liquide ayant une fonctionnalité de plus de 2 et n'ayant pas de groupes hydroxy ;
f) 0 à 40 pour cent en poids d'au moins un di(méth)acrylate cycloaliphatique ou aromatique liquide n'ayant pas de groupes hydroxy ; et
g) 0 à 10 pour cent en poids d'un diluant réactif, la somme des composants a), b), c), d), e), f) et g) représentant 100 pour cent en poids, et les composants c), d), e), f) et g) étant différents, et la composition ne contenant pas d'initiateur de radicaux libres.

2. Composition selon la revendication 1, qui contient 50 à 80, de préférence 60 à 80, de façon davantage préférée 65 à 80, pour cent en poids de composant a).

3. Composition selon la revendication 1, qui contient 0,5 à 6, de préférence 0,5 à 3, de façon davantage préférée 1,0 à 1,5, pour cent en poids de composant b).

4. Composition selon la revendication 1, qui contient 5 à 25, de préférence 7 à 20, de façon davantage préférée 10 à 15, pour cent en poids de composant c).

5. Composition selon la revendication 1, qui contient 5 à 40, de préférence 7 à 35, de façon davantage préférée 10 à 30, de la façon que l'on préfère le plus 12 à 20, pour cent en poids de composant d).

6. Composition selon la revendication 1, qui contient 4 à 30 pour cent en poids de composant e).

7. Composition selon la revendication 1 ou la revendication 6, dans laquelle le composant e) ne représente pas plus de 50 pour cent en poids de la teneur totale en (méth)acrylate.

8. Composition selon la revendication 1, qui contient 5 à 40 pour cent en poids de composant f).

9. Composition selon la revendication 1, dans laquelle le composant (a) contient des cycles oxirane (époxyde) dans la molécule.

10. Composition selon la revendication 1, comprenant :
a1) 20 à 60 pour cent en poids d'un éther polyglycidylique difonctionnel ou de fonctionnalité plus élevée aromatique, ou d'un mélange liquide consistant en éthers polyglycidyliques difonctionnels ou de fonctionnalité plus élevée, aromatiques ;
a2) 0 à 50 pour cent en poids d'un ester glycidylique aliphatique ou cycloaliphatique ;
c) 3 à 30 pour cent en poids d'un composé ou mélange de composés ayant au moins trois groupes insaturés et un groupe hydroxyle dans sa molécule ;
d) 5 à 40 pour cent en poids d'un composé cycloaliphatique ayant au moins 2 groupes hydroxyle et/ou d'un composé cycloaliphatique ayant au moins 2 groupes hydroxyle qui a réagi avec de l'oxyde d'éthylène, de l'oxyde de propylène ou avec de l'oxyde d'éthylène et de l'oxyde de propylène ;
e) 4 à 30 pour cent en poids d'au moins un poly(méth)acrylate liquide ayant une fonctionnalité (méth)acrylate de plus de 2 ;
f) 0 à 20 pour cent en poids d'un ou plusieurs di(méth)acrylates.

11. Composition selon la revendication 1, comprenant :
a) 40 à 80 pour cent en poids d'un éther glycidylique difonctionnel ou de fonctionnalité plus élevée, aliphatique et/ou cycloaliphatique ou d'un mélange de telles résines ;
b) 2 à 7 pour cent en poids d'un photoinitiateur cationique ou d'un mélange de photoinitiateurs cationiques ;
c) 3 à 30 pour cent en poids d'un composé ou mélange de composés ayant au moins trois groupes insaturés et un groupe hydroxyle dans sa molécule ;
d) 10 à 20 pour cent en poids d'un composé phénolique ayant au moins 2 groupes hydroxyle qui a réagi avec de l'oxyde d'éthylène, avec de l'oxyde de propylène ou avec de l'oxyde d'éthylène et de l'oxyde de propylène ;
e) 4 à 10 pour cent en poids d'au moins un poly(méth)acrylate liquide ayant une fonctionnalité (méth)acrylate de plus de 2 ; et
f) 4 à 10 pour cent en poids d'un ou plusieurs di(méth)acrylates.

12. Composition selon la revendication 1, dans laquelle le composant c) contient un composé choisi dans le groupe constitué par :
i) les (méth)acrylates à teneur en hydroxyle représentés par les formules : 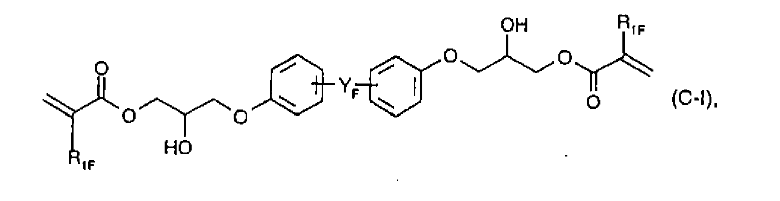 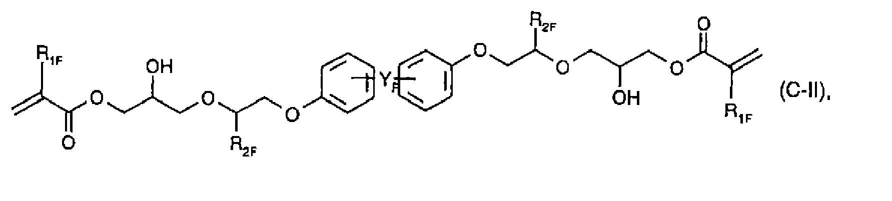 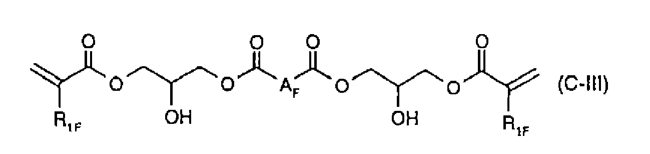 dans lesquelles :
- R_{1F} représente un atome d'hydrogène ou méthyle ;
- Y_{F} est une liaison directe, un alkylène en C₁-C₆, -S-, -O-, -SO-, -SO₂- ou -CO- ;
- R_{2F} représente un groupe alkyle en C₁-C₈, un groupe phényle qui est non substitué ou substitué par un ou plusieurs groupes alkyle en C₁-C₄, groupes hydroxyle ou atomes d'halogène, ou est un radical de la formule -CH₂-OR_{3F} dans laquelle R_{3F} est un groupe alkyle en C₁-C₈ ou un groupe phényle ; et
- A_{F} est un radical choisi parmi les radicaux des formules : 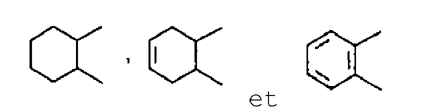 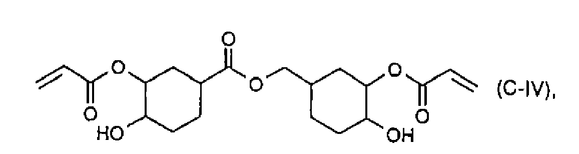 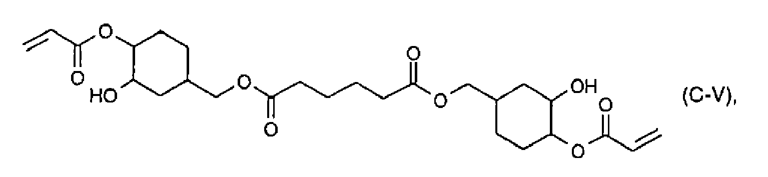
ii) les (méth)acrylates à teneur en hydroxyle selon la formule : 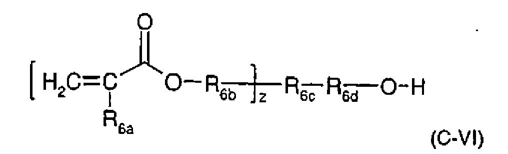 dans laquelle R₆ₐ représente H ou un alkyle en C₁-C₄, R_{6b} et R_{6d} représentent, indépendamment l'un de l'autre, des groupes de liaison linéaires ou ramifiés, divalents, ayant 1 à 20 atomes de carbone qui sont facultativement substitués une ou plusieurs fois par alkyle en C₁-C₄, hydroxyle, ou interrompus une ou plusieurs fois par un groupe carbonyle, R_{6c} est un groupe linéaire ou ramifié multivalent ayant 1 à 4 atomes de carbone, z est un entier de 1 à 3,
ou selon la formule : 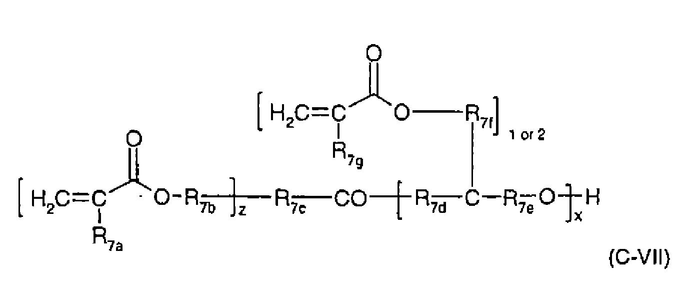 dans laquelle R₇ₐ et R_{7g} représentent indépendamment l'un de l'autre H ou alkyle en C₁-C₄, R_{7c} est un groupe multivalent ayant 1 à 4 atomes de carbone, R_{7b}, R_{7d}, R₇ₑ et R_{7f} représentent, indépendamment les uns des autres, des radicaux linéaires ou ramifiés divalents ayant 1 à 20 atomes de carbone qui sont facultativement substitués une ou plusieurs fois par alkyle en C₁-C₄, hydroxyle, ou interrompus une ou plusieurs fois par un groupe carbonyle, x est un entier de 1 à 4 et z est un entier de 1 à 3,
ou selon la formule 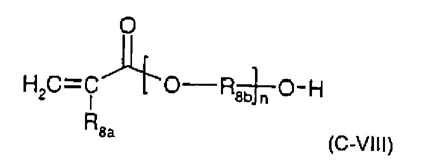 dans laquelle R₈ₐ représente H ou alkyle en C₁-C₄ et R_{8b} représente un groupe linéaire ou ramifié divalent ayant 2 à 6 atomes de carbone,
ou selon la formule 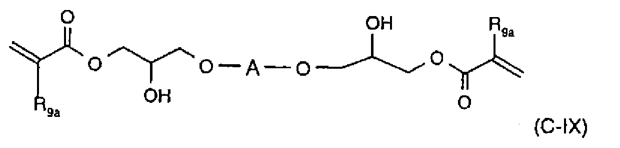 dans laquelle R₉ₐ représente H ou alkyle en C₁-C₄ et A représente un groupe de liaison linéaire ou ramifié divalent ayant 2 à 10 atomes de carbone ;
iii)les éthers vinyliques à teneur en hydroxyle selon les formules : 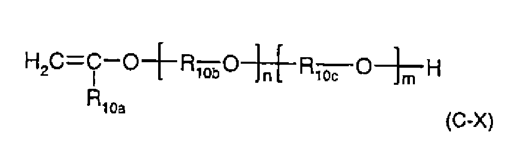 dans lesquelles x et y sont des entiers de 0 à 20, R₁₀ₐ représente H ou alkyle en C₁-C₄, R_{10b} est un groupe aliphatique ayant 3 à 10 atomes de carbone, R_{10c} est un groupe cycloaliphatique, aromatique, aliphatique-aromatique ou aliphatique-cycloaliphatique ayant 5 à 24 atomes de carbone, n est un entier de 0 à 5 et m est un entier de 0 à 5 ; et
iv) les poly(méth)acrylates à teneur en hydroxyle obtenus par le remplacement d'au moins une partie des groupes hydroxyle disponibles des composés de formules (C-I) à (C-IX) par des groupes époxy.

13. Composition selon la revendication 1, dans laquelle le composant c) contient au moins un composé selon la formule : 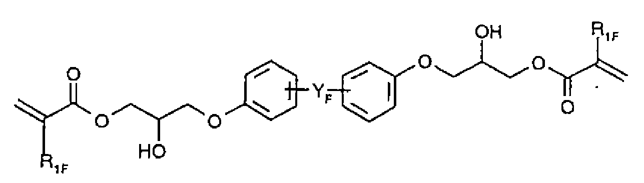 dans laquelle R_{1F} représente hydrogène et Y_{F} représente -C(CH₃)₂-.

14. Composition selon la revendication 1, dans laquelle le composant c) contient au moins un composé selon la formule : 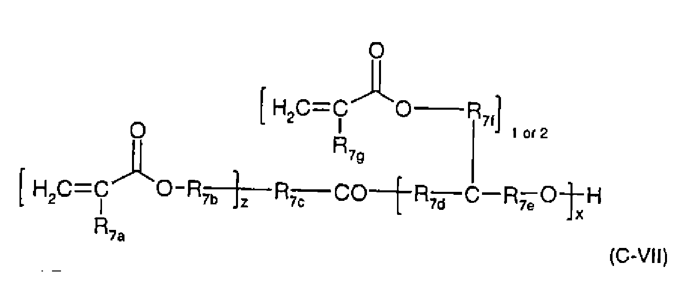 dans laquelle R₇ₐ et R_{7g} représentent H, R_{7b}, R_{7d}, R₇ₑ et R_{7f} sont des groupes méthylène, R_{7c} représente C, z vaut 3 et x vaut 1.

15. Composition selon la revendication 1, dans laquelle le composant c) contient un composé ou mélange de composés ayant plus d'un groupe insaturé par molécule.

16. Composition selon la revendication 1, dans laquelle le composant d) consiste en des composés phénoliques ayant au moins 2 groupes hydroxyle qui ont réagi avec de l'oxyde d'éthylène, de l'oxyde de propylène ou avec de l'oxyde d'éthylène et de l'oxyde de propylène.

17. Procédé de fabrication d'un produit durci, dans lequel une composition selon l'une quelconque des revendications 1 à 16 est traitée par un rayonnement actinique.

18. Procédé de fabrication d'un article de forme tridimensionnelle, dans lequel l'article est construit à partir d'une composition telle que définie à l'une quelconque des revendications 1 à 16, à l'aide d'une séquence alternée répétitive d'étapes (a) et (b), à l'étape (a), une couche de la composition telle que définie à l'une quelconque des revendications 1 à 16, dont une limite est la surface de la composition, est durcie avec l'aide d'un rayonnement approprié à l'intérieur d'une région superficielle qui correspond à l'aire en coupe transversale désirée de l'article tridimensionnel devant être formé, à la hauteur de cette couche, et à l'étape (b), la couche fraîchement durcie est recouverte par une nouvelle couche de la composition liquide, durcissable par rayonnement, cette séquence d'étapes (a) et (b) étant répétée jusqu'à ce qu'un article ayant la forme désirée soit formé, et cet article est, si nécessaire, soumis à un post-durcissement.
